# EUROPÄISCHE PATENTSCHRIFT

(11) **EP 4 355 551 B1**
(45) Veröffentlichungstag und Bekanntmachung des Hinweises auf die Patenterteilung: **24.06.2026**
(21) Anmeldenummer: 22733428.1
(22) Anmeldetag: 15.06.2022
(51) Int. Cl.: B29C 63/02

(54) **MONTAGEVORRICHTUNG FÜR EINEN DISPLAYSCHUTZ**
MOUNTING ARRANGEMENT FOR A DISPLAY PROTECTOR
AGENCEMENT DE MONTAGE POUR UN DISPOSITIF DE PROTECTION D?ÉCRAN

(30) Priorität: 16.06.2021 DE 102021115597
(43) Veröffentlichungstag der Anmeldung: 24.04.2024
(73) Patentinhaber: E.V.I. GmbH, 82061 Neuried (DE)
(72) Erfinder: KOPP, Ulrich, 82061 Neuried (DE); VOGTMANN, Markus, 82061 Neuried (DE)
(74) Vertreter: TBK
(86) Internationale Anmeldenummer: PCT/EP2022/066306
(87) Internationale Veröffentlichungsnummer: WO 2022/263511

(56) Entgegenhaltungen:
- WO-A1-2014/167433
- DE-A1- 102013 021 563
- DE-A1- 102020 134 159
- DE-U1- 202015 009 478

## Beschreibung

### Technisches Gebiet

Die vorliegende Erfindung betrifft eine Montagevorrichtung für einen Displayschutz.

### Stand der Technik

In dem Stand der Technik wird eine Montagevorrichtung für einen Displayschutz verwendet, um einem Anwender ein Anbringen (Fügen) des Displayschutzes an ein Display eines Gerätes zu ermöglichen.

DE 10 2020 134 159 A1 zeigt eine Montagevorrichtung gemäß dem Oberbegriff des Anspruchs 1 bzw. 2 der vorliegenden Erfindung. Weitere konventionelle Montagevorrichtungen sind in DE20 2015 009 478 U1, DE 10 2013 021 563 A1 und WO 2014/ 167 433 A1 gezeigt.

### Zusammenfassung der Erfindung

Der Erfindung liegt die Aufgabe zugrunde, eine Montagevorrichtung für einen Displayschutz bereitzustellen, der ein verbessertes Fügen des Displayschutzes an ein Display eines Gerätes ermöglicht. Außerdem soll die Montagevorrichtung kostengünstig und ressourcenschonend herstellbar sein. Die präzise Positionierung des Displayschutzes auf dem Display ist wegen der im Displayschutz enthaltenen Aussparungen für z. B. Sensoren, Kameras und Lautsprecher besonders wichtig.

Die Aufgabe wird mit den Merkmalen des Anspruchs 1 bzw. Anspruchs 2gelöst. Vorteilhafte Weiterbildungen sind Gegenstand der Unteransprüche.

Eine erfindungsgemäße Montagevorrichtung gemäß Anspruch 1 für ein Fügen eines Displayschutzes an ein Display eines Geräts beinhaltet ein Anlageelement, an dem der Displayschutz oder das Gerät positionierbar ist und das einen ersten Schenkel mit einem ersten Ausrichtabschnitt aufweist, an dem der Displayschutz oder das Gerät in einer ersten Richtung ausrichtbar ist, und einen zweiten Schenkel mit einem zweiten Ausrichtabschnitt aufweist, an dem der Displayschutz in einer zweiten Richtung ausrichtbar ist, einen Schenkelverbindungsabschnitt, der die beiden Schenkel in einem festen Winkel verbindet. Weiterhin ist zumindest ein erstes und zumindest ein zweites Positionierbauteil mit einem Koppelabschnitt vorgesehen, der mit den Schenkeln koppelbar ist, und einem Positionierabschnitt, der bezüglich des ersten Ausrichtabschnitts und bezüglich des zweiten Ausrichtabschnittes ausgerichtet ist, wenn das erste Positionierbauteil mit dem ersten Schenkel und das zweite Positionierbauteil mit dem zweiten Schenkel gekoppelt ist, wobei das Gerät oder der Displayschutz mit zumindest einem Positionierabschnitt zum Ausrichten in Kontakt bringbar ist, um Gerät und Displayschutz zueinander auszurichten, dadurch gekennzeichnet, dass die Montagevorrichtung aus einem L-förmigen Anlageelement besteht, wobei der erste und der zweite Schenkel so angeordnet sind, dass sich für das Anlageelement eine L-Form ergibt.

Eine erfindungsgemäße Montagevorrichtung nach Anspruch 2 für ein Fügen eines Displayschutzes an ein Display eines Geräts beinhaltet ein Anlageelement, an dem das Gerät positionierbar ist und das einen ersten Schenkel mit einem ersten Ausrichtabschnitt aufweist, an dem das Gerät oder der Displayschutz in einer ersten Richtung ausrichtbar ist, und einen zweiten Schenkel mit einem zweiten Ausrichtabschnitt aufweist, an dem das Gerät oder der Displayschutz in einer zweiten Richtung ausrichtbar ist. Weiterhin ist ein Schenkelverbindungsabschnitt vorgesehen, der die beiden Schenkel in einem festen Winkel verbindet, und zumindest ein erstes und zumindest ein zweites Positionierbauteil mit einem Koppelabschnitt, der mit den Schenkeln koppelbar ist, und einem Positionierabschnitt, der bezüglich des ersten Ausrichtabschnitts und bezüglich des zweiten Ausrichtabschnittes ausgerichtet ist, wenn das erste Positionierbauteil mit dem ersten Schenkel und das zweite Positionierbauteil mit dem zweiten Schenkel gekoppelt ist, wobei der Displayschutz oder das Gerät mit zumindest einem Positionierabschnitt zum Ausrichten in Kontakt bringbar ist, um Gerät und Displayschutz zueinander auszurichten, dadurch gekennzeichnet, dass die Montagevorrichtung aus einem U- oder J-förmigen Anlageelement besteht, wobei das Anlageelement einen dritten Schenkel mit einem dritten Ausrichtabschnitt aufweist, den ein Schenkelverbindungsabschnitt in einem festen Winkel mit dem ersten und/oder zweiten Schenkel verbindet, wobei die Schenkel so angeordnet sind, dass sich für das Anlageelement eine U- oder J-förmige Form ergibt.

Ein Gerät kann beispielsweise ein Telefon, Smartphone, Tablet oder E-Book-Reader sein. Das Gerät weist ein Display auf. Beispielsweise ist das Display ein LCD- oder OLED-Bildschirm eines Smartphones, inklusive der konventionellen Verglasung des Displays.

Eine Displaynormalenrichtung ist eine Richtung, die senkrecht zu dem Display steht, wenn das Gerät mit dem Rahmen positioniert ist. Eine Fügefläche ist eine Fläche, in der sich das Display und der Displayschutz während dem Fügen berühren. Die Fügefläche liegt somit auf der Displayoberfläche, wenn das Gerät mit dem Rahmen positioniert ist. Die Fügefläche kann eben oder gekrümmt sein.

Anlageelemente und Positionierbauteile können so gestaltet sein, dass das Gerät von einer Seite und der Displayschutz von einer anderen Seite aus für ein Fügen in Kontakt mit der Montagevorrichtung gebracht werden kann.

Anlageelemente und Positionierbauteile können so gestaltet sein, dass das Gerät und der Displayschutz von der gleichen Seite für ein Fügen in Kontakt mit der Montagevorrichtung gebracht werden kann.

In einer Montagevorrichtung sind Ausrichtabschnitte und Positionierabschnitte in zwei separaten Bauteilen vorgesehen, die miteinander koppelbar sind. Die Toleranzkette zwischen dem Ausrichtabschnitt und dem Positionierabschnitt ist damit sehr kurz und ein Displayschutz kann mit hoher Positioniergenauigkeit an ein Display gefügt werden.

Das Gerät und das Display sind ohne Anlageelement in drei Raumrichtungen verschieblich und um die drei Raumrichtungen verdrehbar. Insgesamt hat sowohl das Gerät, als auch der Displayschutz sechs Freiheitsgrade bzgl. seiner Bewegung. Dabei sind jeweils drei translatorische Freiheitsgrade und drei rotatorische Freiheitsrade vorhanden.

Ein erster Ausrichtabschnitt und ein zweiter Ausrichtabschnitt dient dazu, zwei translatorische Freiheitsgrade und einen rotatorischen Freiheitsgrad des Geräts bzw. des Displayschutzes bzgl. der Montagevorrichtung zu beschränken.

Zwei Positionierabschnitte dienen dazu, zwei translatorische und einen rotatorischen Freiheitsgrad des Displayschutzes bzw. Geräts bzgl. der Montagevorrichtung zu beschränken.

Ist das Gerät mit der Montagevorrichtung positioniert, dient das Display des Geräts als ein weiterer Positionierabschnitt für den Displayschutz, der den dritten translatorischen Freiheitsgrad und die verbleibenden rotatorischen Freiheitsgrade des Displayschutzes bzgl. der Montagevorrichtung und dem Gerät beschränkt.

Hierbei wird zunächst das Gerät an den beiden Schenkeln des Anlageelements bzw. den Positionierbauteilen positioniert. Anschließend wird eine Kante des Displayschutzes in Kontakt mit dem Display gebracht und gleichzeitig auf der gleichen Seite des Displayschutzes mit einem Positionierabschnitt bzw. einem Ausrichtabschnitt in Kontakt gebracht. Zu diesem Zeitpunkt ist der Displayschutz translatorisch bzgl. der Montagevorrichtung und dem Gerät positioniert. Für ein Fügen des Displayschutzes an das Display wird der Displayschutz mittels einem der beiden verbleibenden rotatorischen Freiheitsgrade um zumindest eine von den zwei Raumrichtungen geschwenkt, die translatorisch mittels den Ausrichtabschnitten beschränkt sind.

Auch eine umgekehrte Positionierreihenfolge ist möglich, in der zunächst der Displayschutz mit dem Anlageelement bzw. Positionierbauteil positioniert wird und anschließend das Gerät bezüglich dem Anlageelement mit Displayschutz positioniert wird.

Schenkel können aus der Displaynormalentrichtung betrachtet eine einfache beispielsweise rechteckige Form haben. Das hat den Vorteil, dass die Montagevorrichtung einfach und kostengünstig herstellbar ist.

Bei Ausrichtabschnitten ist es ausreichend, wenn ein Ausrichtabschnitt einen Vorsprung beispielsweise in Form einer Spitze aufweist, mit der er das Gerät bzw. den Displayschutz berührt. Das hat den Vorteil, dass der Anwender leicht erkennen kann, ob das Gerät bzw. der Displayschutz korrekt an dem Ausrichtabschnitt anliegt, da der Anwender lediglich eine Stelle kontrollieren muss. Gleiches gilt für einen Positionierabschnitt.

Ein Ausrichtabschnitt kann auch mehrere Spitzen aufweisen, mit denen er das Gerät bzw. den Displayschutz berührt. Das hat den Vorteil, dass mit einem Ausrichtabschnitt nicht nur ein translatorischer Freiheitsgrad beschränkt werden kann, sondern gleichzeitig ein rotatorischer Freiheitsgrad beschränkt werden kann. Gleiches gilt für einen Positionierabschnitt.

Außerdem können Ausrichtabschnitte gekrümmte Flächen, ebene Flächen, Kanten oder gerade Flächen haben, die an dem Gerät oder dem Displayschutz anliegen. Es können somit Bereiche zwischen den anliegenden Stellen eines Ausrichtabschnittes zurückgenommen sein, so dass sie einen Abstand zu dem Gerät oder dem Displayschutz aufweisen. Somit kann das benötigte Material zur Herstellung der Montagevorrichtung reduziert werden. Gleiches gilt für einen Positionierabschnitt.

Außerdem kann ein Ausrichtabschnitt Vorsprünge oder Vertiefungen aufweisen, die entsprechend einer Gerätekontur bzw. Displayschutzkontur geformt sind. Diese Vorsprünge und Vertiefungen können dazu dienen, es dem Anwender zu erleichtern, zu erkennen, in welcher Orientierung das Gerät bzw. der Displayschutz mit dem Ausrichtabschnitt positioniert werden muss, um präzise an eine dafür vorgesehene Fläche in Kontakt gebracht zu werden. Gleiches gilt für einen Positionierabschnitt.

Koppelabschnitte können Vorsprünge, Vertiefungen oder Durchgänge mit einer bestimmten Form in den Positionierbauteilen sein, beispielsweise einer Nippel-Form, die koppelbar mit entsprechenden Bereichen in den Schenkeln, beispielsweise Nippel-Aufnahmen, sind. Diese entsprechenden Bereiche sind Rahmenkoppelabschnitte. Beispielsweise können Koppelabschnitte mit den Schenkeln Druckknopf-artig formschlüssig gekoppelt werden. Es kann ein Federelement beinhalten, das den Nippel in dem Schenkel verriegelt. Der Verbindungsmechanismus zwischen den Koppelabschnitten kann aber auch magnetisch sein. Die Größe des Durchgangs oder der Aussparung kann bezüglich der Form des Koppelbschnittes so gewählt sein, dass Koppelabschnitt mittels Reibschluss oder Klemmen an dem Schenkel koppelbar ist.

Vorzugsweise weisen Rahmenkoppelabschnitte in einem Schenkel einen möglichst großen Abstand zueinander auf.

Wenn das Positionierbauteil mit einem Schenkel gekoppelt ist, steht ein Positionierbauteil im Wesentlichen auf einer Seite des Anlageelements vor, auf der auch das Gerät bzw. der Displayschutz an dem Anlageelement positioniert wird.

Vorzugsweise sind alle Positionierbauteile gleich gestaltet und stehen gleich weit in die gleiche Richtung vor. Somit können alle Positionierbauteile auf die gleiche Weise hergestellt werden und die Herstellungskosten können reduziert werden.

Der Winkel, in dem die Schenkel zueinander positioniert sind, orientiert sich an der Außenkontur des Gerätes. Vorzugsweise stehen die Schenkel im Wesentlichen senkrecht zueinander.

Bei einer erfindungsgemäßen Montagevorrichtung können die Positionierbauteile die Ausrichtabschnitte des Anlageelements überragen, betrachtet entgegen der Displaynormalenrichtung, wenn die Positionierbauteile mit den Schenkeln gekoppelt sind und das Gerät mit der Montagevorrichtung positioniert ist.

Bei einer erfindungsgemäßen Montagevorrichtung kann das Anlageelement oder das Positionierbauteil einen Auflageabschnitt aufweisen, an dem das Display und/oder das Gerät die Montagevorrichtung berührt.

Durch den Auflageabschnitt wird der dritte translatorischer Freiheitsgrad des Geräts bezüglich der Montagevorrichtung eingeschränkt. Dadurch ist das Gerät translatorisch und rotatorisch bezüglich der Montagevorrichtung eindeutig positionierbar und ein positionsgenaues Fügen des Displayschutzes an das Display wird unterstützt.

Der Auflageabschnitt kann ein ebener Abschnitt sein, an dem das Display und/oder das Gerät flächig anliegen. Der Auflageabschnitt kann auch aus zumindest drei Spitzen oder eine Kante und einer Spitze bestehen. Der Auflageabschnitt muss lediglich eine Ebene definieren können, um seine Aufgabe zu erfüllen.

Der Auflageabschnitt kann eine Seite, von der aus das Gerät für ein Fügen in Kontakt mit der Montagevorrichtung gebracht wird, komplett abdecken. Der Auflageabschnitt kann auch bezüglich ihn umgebenden Flächen in der Montagevorrichtung versenkt sein.

Der Auflageabschnitt kann sich bis zu Positionierabschnitten bzw. Ausrichtabschnitten erstrecken.

Ausrichtabschnitte einer erfindungsgemäßen Montagevorrichtung können ebene Flächen sein.

Die Montagevorrichtung kann insgesamt oder teilweise mittels Stanzen, Laserstrahlschneiden, Wasserstrahlschneiden oder der gleichen hergestellt werden

Ebene Flächen sind in der Regel leicht fertigbar. Insofern können die Herstellungskosten reduziert werden.

Wird die ebene Fläche geschnitten, beispielsweise mittels Wasserstrahlschneiden, kann die ebene Fläche mit einer hohen Schnittgeschwindigkeit hergestellt werden. Dadurch kann der Maschinendurchsatz erhöht werden und die Herstellkosten können reduziert werden.

In einer erfindungsgemäßen Montagevorrichtung können Ausrichtabschnitte in einem Winkel zu der Fügefläche angeordnet sein.

Beispielsweise sind die Ausrichtabschnitte senkrecht zu der Fügefläche angeordnet. Das hat den Vorteil, dass die Ausrichtabschnitte als Führungsflächen verwendet werden können, um den Displayschutz für ein Fügen in Displaynormalenrichtung zu bewegen. Wenn der Displayschutz in Kontakt mit dem Display kommt, hat der Displayschutz bereits die gewünschte Position in der Fügefläche. Somit kann verhindert werden, dass der Displayschutz in der Fügefläche bewegt werden muss, wenn er bereits Kontakt zu dem Display hat.

Dadurch werden entstehende Kratzer auf dem Display und das Kleben des Displayschutzes an falscher Position wirksam vermieden.

Ein Ausrichtabschnitt kann auch geneigt zu der Fügefläche sein. Vorzugsweise ist der Ausrichtabschnitt dann so geneigt, dass er mit dem Display bzw. dem Gerät einen spitzen Winkel einschließt bezüglich der Seite, von der aus der Displayschutz mit dem Ausrichtabschnitt positioniert wird. Wird der Displayschutz während dem Fügen in Richtung der Ausrichtabschnitte gedrückt, um seine korrekte Anlage an denselben zu gewährleisten, erfährt der Displayschutz gleichzeitig eine Kraftkomponente in Richtung des Displays an das er gefügt werden soll. Somit wird der Displayschutz bereits durch ein Ausrichten in der Fügefläche auf das Display gedrückt. Bereits bei einem Erstkontakt zwischen Displayschutz und Display wird dadurch eine Blasenbildung in den Fügefläche vermieden und das Fügen wird für den Anwender vereinfacht.

Gleiches gilt für einen Positionierabschnitt.

Ausrichtabschnitte einer erfindungsgemäßen Montagevorrichtung sind zueinander in einem in der Fügefläche befindlichen Winkel ausgerichtet.

Der Winkel, in dem die Ausrichtabschnitte zueinander ausgerichtet sind, orientiert sich an der Außenkontur des Displayschutzes bzw. Gerätes. Vorzugsweise stehen die Ausrichtabschnitte im Wesentlichen senkrecht zueinander. Oder zumindest in der Fügefläche befindliche Kanten von Ausrichtabschnitten stehen im Wesentlichen senkrecht zueinander, wenn Ausrichtabschnitte nicht senkrecht zu der Fügefläche angeordnet sind.

Gleiches gilt für einen Positionierabschnitt.

Ausrichtabschnitte einer erfindungsgemäßen Montagvorrichtung können mittels einem Ausrichtverbindungsabschnitt verbunden sein.

Die Ausrichtverbindungsabschnitte dienen dazu, Ausrichtabschnitte zueinander zu positionieren. Die Ausrichtverbindungsabschnitte sind so geformt, dass der Displayschutz bzw. das Gerät an entsprechenden Stellen genug Spiel hat, dass das Gerät bzw. der Displayschutz mit den dafür vorgesehenen Stellen in Kontakt mit den Ausrichtabschnitten gebracht werden kann.

Beispielsweise können die Ausrichtverbindungsabschnitte betrachtet aus der Displaynormalenrichtung eine Bogenform haben.

Betrachtet aus der Displaynormalenrichtung können Ausrichtabschnitte auch eine Ecke oder Kante aufweisen oder polygonartig gestaltet sein. Dadurch kann ein Spiel oder Abstand hinsichtlich des Geräts bzw. Displayschutzes vergrößert werden und ein korrektes Fügen sichergestellt werden.

Der erste und der zweite Schenkel einer erfindungsgemäßen Montagevorrichtung kann so angeordnet sein, dass sich für das Anlageelement eine L-Form ergibt.

Dabei können die Schenkel unterschiedliche Längen haben. Die unterschiedlichen Längen können sich an Dimensionen des Displayschutzes bzw. Gerätes orientieren. Dadurch kann dem Anwender angezeigt werden in welcher Orientierung der Displayschutz bzw. das Gerät mit dem Anlageelement positioniert werden soll und eine Handhabung der Montagevorrichtung wird erleichtert.

Die Schenkel können auch die gleiche Länge haben. Das hat den Vorteil, dass die Schenkel mit dem gleichen Werkzeug verarbeitet werden können. Dadurch können die Herstellungskosten für die Montagevorrichtung reduziert werden.

Außerdem können für ein Gerät zwei L-förmige Anlageelemente verwendet werden, die an benachbarten Ecken des Geräts anliegen. Dabei können die beiden L-förmigen Anlageelemente die gleiche Gestaltung aufweisen. Dadurch kann eine große Stückzahl gleicher Anlageelemente hergestellt werden, wodurch die Herstellungskosten für ein einzelnes Anlageelement reduziert werden.

In diesem Fall kann der Displayschutz mittels Anlegen an zwei benachbarte Ausrichtabschnitte eines Schenkels eines ersten Anlageelements und eines zweiten Anlageelements bezüglich dem Gerät positioniert werden. Dabei können die Ausrichtabschnitte so gestaltet sein, dass sie möglichst weit in einer Längen- oder Querrichtung entfernt voneinander und anliegend an dem Gerät oder dem Displayschutz positioniert sind. Dies unterstützt ein positionsgenaues Fügen.

Ein Anlageelement einer erfindungsgemäßen Montagevorrichtung kann einen dritten Schenkel mit einem dritten Ausrichtabschnitt aufweisen, den ein Schenkelverbindungsabschnitt in einem festen Winkel mit dem ersten und/oder zweiten Schenkel verbindet.

Durch den dritten Ausrichtabschnitt kann ein Freiheitsgrad des Geräts bzw. des Displayschutzes in einer translatorischen Richtung weiter eingeschränkt werden.

Sind zwei Ausrichtabschnitte einander bezüglich dem Gerät bzw. Displayschutz gegenüberliegend auf unterschiedlichen Seiten des Gerätes bzw. Displayschutzes angeordnet, kann damit ein Bewegungsbereich festgelegt werden, in dem sich das Gerät bzw. der Displayschutz in einer translatorischen Richtung während dem Fügen bewegen kann. Somit kann mit drei Ausrichtabschnitten das Gerät bzw. der Displayschutz in einer translatorischen Richtung in seiner Position festgelegt und in einer anderen translatorischen Richtung in seiner Bewegung beschränkt werden. Somit wird das Fügen mit einer hohen Positioniergenauigkeit unterstützt.

Die Schenkel in einer erfindungsgemäßen Montagevorrichtung können so angeordnet sein, dass sich für das Anlageelement eine U-Form ergibt.

Wenn zwei Ausrichtabschnitte bezügliche dem Gerät oder dem Displayschutz gegenüberliegend angeordnet sind und die beiden Ausrichtabschnitte in unterschiedlichen Schenkeln vorgesehen sind, ergibt sich für das Anlageelement eine U-Form.

Es ist aber auch möglich zwei Schenkel an einem mittleren Schenkel so zu positionieren, dass sich für das Anlageelement eine T-Form ergibt. Der mittlere Schenkel kann auf zwei bezüglich dem mittleren Schenkel gegenüberliegenden Seiten Ausrichtabschnitte haben. Mit dieser Gestaltung kann die eine Seite des T-förmigen Anlageelementes für das Fügen eines anderen Displayschutzes an ein anderes Gerät als die andere Seite des Anlageelementes vorgesehen sein. Dadurch wird die Funktionalität der Montagevorrichtung erhöht und die Herstellungskosten verglichen mit zwei separaten Montagevorrichtungen für zwei unterschiedliche Geräte bzw. Displayschutze können reduziert werden.

Dabei können die Schenkel unterschiedliche Längen haben. Die unterschiedlichen Längen können sich an Dimensionen des Displayschutzes oder Gerätes orientieren. Dadurch kann dem Anwender angezeigt werden in welcher Orientierung der Displayschutz bzw. das Gerät mit dem Anlageelement positioniert werden soll und die Handhabung der Montagevorrichtung wird erleichtert.

Die Schenkel können beispielsweise Längen haben, die der Breite und der Länge eines Gerätes oder Displayschutzes entsprechen. Die Schenkel können aber auch Längen haben, die kleiner sind, beispielsweise halb so groß sind, wie die Breite und Länge eines Gerätes bzw. Displayschutzes. Dadurch kann Material gespart werden, um die Montagevorrichtung herzustellen und die Herstellkosten können gesenkt werden.

Die Schenkel können auch die gleiche Länge haben. Das hat den Vorteil, dass die Schenkel mit einem gleichen Werkzeug verarbeitet werden können. Dadurch können die Herstellkosten für die Montagevorrichtung reduziert werden.

Die Schenkel einer erfindungsgemäßen Montagevorrichtung können eine unterschiedliche Länge aufweisen und so angeordnet sind, dass sich für das Anlageelement eine J-Form ergibt.

Weisen zumindest zwei Schenkel, die sich gegenüberliegen, unterschiedliche Längen auf, so ergibt sich für das Anlageelement eine J-Form. Dabei kann der kurze Schenkel so positioniert sein, dass er Bedienelemente oder Vorsprünge an dem Gerät freigibt. Somit wird ein positionsgenaues Fügen unterstützt.

Eine erfindungsgemäße Montagevorrichtung kann zumindest ein weiteres Positionierbauteil mit Positionierabschnitt aufweisen, das an dem ersten Schenkel, dem zweiten Schenkel oder dem dritten Schenkel angeordnet ist.

Durch den dritten Positionierabschnitt kann ein Freiheitsgrad des Geräts oder des Displayschutzes in einer translatorischen Richtung weiter eingeschränkt werden.

Sind zwei Positionierabschnitte einander bezüglich dem Gerät bzw. Displayschutz gegenüberliegend auf unterschiedlichen Seiten des Gerätes bzw. Displayschutzes angeordnet, kann damit ein Bewegungsbereich festgelegt werden, in dem sich das Gerät bzw. der Displayschutz in einer translatorischen Richtung während dem Fügen bewegen kann. Somit kann mit drei Positionierabschnitten das Gerät bzw. der Displayschutz in einer translatorischen Richtung in seiner Position festgelegt und in einer anderen translatorischen Richtung in seiner Bewegung beschränkt werden. Somit wird das Fügen mit einer hohen Positioniergenauigkeit unterstützt.

Positionierbauteile einer erfindungsgemäßen Montagevorrichtung können mittels Positionierbauteilkoppelabschnitten miteinander koppelbar sein.

Das hat den Vorteil, dass sich die gekoppelten Positionierbauteile gegenseitig stützen und die Montagevorrichtung somit eine erhöhte Stabilität aufweist. Ein Fügen mit hoher Präzision wird ermöglicht.

Beispielsweise können Positionierbauteile miteinander gekoppelt sein, die an unterschiedlichen Seiten des Gerätes bzw. des Displayschutzes während dem Fügen anliegen. Dann schließen die Positionierbauteile einen Winkel ein, der sich nach den Winkeln von Ausrichtabschnitten und Positionierabschnitten richten kann.

Beispielsweise können Positionierbauteile gekoppelt werden, die senkrecht zueinander stehen. Dann verhindern die Positionierbauteile ein Verkippen des jeweils andren Positionierbauteils.

Die Positionierbauteile können über mehrere Schenkel hinweg miteinander verbunden sein. Dabei können entweder Koppelungen zwischen einem Positionierbauteil und einem Schenkel entfallen oder Koppelungen zwischen zwei Schenkel, deren Positionierbauteile gekoppelt sind, können entfallen.

Die Positionierbauteilkoppelabschnitte können beispielsweise so gestaltet sein, dass in einem Positionierbauteil ein Schlitz ist, wobei in dem anderen Positionierbauteil ein Steg ist. Der Schlitz hat die Breite des Steges und kann somit mit dem Steg in Verbindung gebracht werden.

Wenn der Steg etwas breiter ist als der Schlitz, kann der Steg in dem Schlitz mittels Reibschluss befestigt werden. Dabei hängt das Übermaß, um wie viel der Steg breiter sein muss, als der Schlitz von den Werkstoffeigenschaften der Positionierbauteile ab. Wird ein Metallmaterial verwendet, das einen großen E-modul hat, sind einige 1/1000 mm für das Übermaß ausreichend. Wird ein Material verwendet, das einen geringen E-Modul hat, wie z.B. Pappe, MDF, HDF, Sperrholz, etc. oder ein Materialmix, sind einige 1/100 mm für das Übermaß ausreichend.

Die Gestaltung des Positionierkoppelabschnittes kann aber auch eine beliebige Kombination aus Erhebung und Vertiefung in den entsprechenden Stützbauteilen sein. Die Gestaltung muss lediglich dazu dienen, dass sich die Erhebung bzgl. seiner Vorsprungsachse so an der Vertiefung abstützen kann, dass die Erhebung seine Orientierung auch unter äußerem Krafteinfluss beibehalten kann.

Ein Positionierabschnitt einer erfindungsgemäßen Montagevorrichtung kann mit einem Haftelement versehen sein, das so mit dem Gerät oder dem Displayschutz in Kontakt kommt, dass das Positionierbauteil an dem Gerät oder dem Displayschutz haftet.

Ein Ausrichtabschnitt einer erfindungsgemäßen Montagevorrichtung kann mit einem Haftelement versehen sein, das so mit dem Gerät oder dem Displayschutz in Kontakt kommt, dass das Anlageelement an dem Gerät oder dem Displayschutz haftet.

Dadurch kann die Position des Gerätes oder Displayschutzes, in die es in der Montagevorrichtung für ein Fügen gebracht wird, fixiert werden. Das hat den Vorteil, dass der Anwender nicht mehr auf die Relativpositionen von Gerät oder Displayschutz und Montagevorrichtung achten muss, wenn er das Gerät oder den Displayschutz mit der Montagevorrichtung positioniert hat. Der Anwender kann sich somit ganz auf das Fügen des Displayschutzes an das Display konzentrieren. Dadurch wird die Handhabung der Montagevorrichtung verbessert und ein präziser Fügevorgang unterstützt.

Beispielseise können Klebebereiche als Haftelemente verwendet werden. Klebebereiche sind sehr günstig in der Herstellung. Somit kann die Montagevorrichtung kostengünstig hergestellt werden.

Es können auch Magnete als Haftelemente verwendet werden. Das hat den Vorteil, dass die Haftelemente mehrmals für einen Fügevorgang verwendet werden können. Somit werden die natürlichen Ressourcen geschont.

Es können auch Klebestreifen mit Abziehelementen als Haftelemente verwendet werden. Dabei sind mehrere Klebestreifen aufeinander vorgesehen. In diesem Fall kommt ein unverwendeter Klebestreifen zum Vorschein, wenn ein oberster Klebestreifen abgezogen wird. Diese Gestaltung vereint die Vorteile von Magneten und Klebebereichen.

Haftelemente können auch so gestaltet sein, dass sie mit dem Gerät oder dem Displayschutz einen Formschluss bilden, wie beispielsweise Haken oder Vorsprünge, die in bestimmte Vertiefungen, wie einem Mikrofoneingang, einem Kopfhöreranschluss und der Gleichen, des Gerätes oder des Displayschutzes einrasten.

Ferner können die Haftelemente so gestaltet sein, dass sie an dem Display des Gerätes oder in Displaynormalenrichtung an dem Displayschutz haften oder anliegen.

Ein Haftelement einer erfindungsgemäßen Montagevorrichtung kann mit einer Haftelementabdeckung abgedeckt sein.

Das stellt sicher, dass das Haftelement nicht verdreckt. Dadurch wird sichergestellt, dass das Haftelement die gewünschte Funktion zumindest bis zu dem Zeitpunkt bereitstellen kann, bis die Abdeckung entfernt wurde.

Die Haftelementabdeckung kann beispielsweise eine Kunststofffolie sein, die auf einem Klebestreifen als Haftelement aufgebracht ist. Die Haftelementabdeckung kann auch eine Papierschicht mit einer zusätzlichen Beschichtung auf einer Seite sein, die das Lösen der Papierschicht von dem Haftelement erleichtert. Im Falle der Papierfolie kann die Montagevorrichtung recyclebar sein und somit umweltverträglich hergestellt sein.

In dem Fall, dass das Haftelement magnetisch ist, kann auch eine starre Abdeckung, beispielsweise aus Kunststoff oder Pappe, die form- oder reibschlüssig an der Montagevorrichtung angebracht ist, als Haftelementabdeckung dienen.

Ein Anlageelement einer erfindungsgemäßen Montagevorrichtung kann einen Griffabschnitt aufweisen.

Ein Griffabschnitt kann auch in einem Positionierbauteil integriert sein.

Der Griffabschnitt ermöglicht ein einfaches Positionieren des Anlageelementes mit dem Gerät oder dem Displayschutz ohne dass der Anwender dabei andere Bereiche der Montagevorrichtung berühren muss.

Wenn beispielsweise Positionierabschnitte oder Ausrichtabschnitte mit einem Haftelement versehen sind, die freiliegen, um daran ein Gerät bzw. Displayschutz zu positionieren, kann der Anwender das Gerät bzw. den Displayschutz und die Montagevorrichtung zueinander führen, ohne dass dabei die Haftelemente mit anderen Elementen in Berührung kommen als mit den dafür vorgesehenen Bereichen des Gerätes bzw. Displayschutzes. Das verhindert ein Verdrecken der Haftelemente und ein ungewünschtes Verrutschen der Montagevorrichtung und des Gerätes bzw. Displayschutzfolie relativ zueinander.

Ein Griffabschnitt kann in einem Schenkel, Schenkelverbindungsabschnitt oder einem Ausrichtverbindungsabschnitt angeordnet sein. Vorzugsweise ist der Griffabschnitt an einer Stelle des Anlageelements angeordnet, um die herum sich die auftretenden Momentenwirkungen, durch die für ein Positionieren des Gerätes bzw. Displayschutzes an dem Anlageelement auftretenden Kräfte, sich weitestgehend ausgleichen.

Für den Fall dass sich auftretende Momente nicht komplett ausgleichen, kann der Anwender den verbleibenden Momenten über den Griffabschnitt entgegenwirken und kann ein Verrutschen der Montagevorrichtung verhindern.

Liegt beispielsweise ein L-förmiges Anlageelement vor, ist es zweckmäßig, das Griffelement in einem Bereich anzuordnen, in dem die beiden Schenkel zusammenlaufen. In diesem Fall gleichen sich die Momentenwirkungen der Kräfte, die auf den ersten und den zweiten Ausrichtabschnitt aufgebracht werden, bis zu einem gewissen Grad aus, da sich das Griffelement in einem mittleren Bereich zwischen den Ausrichtabschnitten befindet, betrachtet aus der Richtung, aus der die Kräfte aufgebracht werden.

In Displaynormalenrichtung betrachtet, kann ein Griffelement teilkreisförmig ausgeführt sein. Dabei bestimmt der Durchmesser des Teilkreises die Griffigkeit des Griffelements. Mit großem Durchmesser wird die Griffigkeit des Griffelements erhöht.

Zweckmäßig ist ein Durchmesser von 1 bis 2 cm. In diesem Fall ist die Griffigkeit des Griffelements sehr gut. Außerdem kann das Griffelement in dieser Größenordnung gut in dem mittleren Bereich der Schenkel angeordnet werden ohne viel zusätzliches Material zu benötigen. Somit ist eine ressourcenschonende Herstellung möglich.

Das Griffelement kann zur Erhöhung der Griffigkeit eine raue, gerändelte, gewellte oder gezackte Oberfläche aufweisen.

Das Griffelement kann auch eine rechteckige Plattenform aufweisen, die in Displaynormalenrichtung von dem Anlageelement vorsteht. Die rechteckige Plattenform ist leicht herstellbar, wodurch die Herstellkosten gering bleiben. Außerdem lässt sich eine Plattenform sehr gut greifen, wodurch ein Fügen mit hoher Genauigkeit unterstützt wird.

Der Griffabschnitt kann integral mit dem Anlageelement ausgeführt sein. Der Griffabschnitt kann auch koppelbar mit dem Anlageelement ausgeführt sein.

Beispielsweise kann der Griffabschnitt eine rechteckige Plattenform aufweisen und mit einer schlitzförmigen Öffnung in dem Anlageelement gekoppelt werden. Dabei kann die Breite des Schlitzes der Dicke der Platte entsprechen, um ein einfaches Koppeln zu ermöglichen.

Der Griffabschnitt kann auch ein gewisses Übermaß aufweisen, durch das der Griffabschnitt mittels Reibschluss daran gehindert wird aus der dafür vorgesehenen Öffnung in dem Anlageelement zu rutschen.

Ein Schenkelverbindungsabschnitt einer erfindungsgemäßen Montagevorrichtung kann integral mit Schenkeln ausgeführt sein.

In diesem Fall ist die Teilezahl der Montagevorrichtung reduziert und die Montagevorrichtung ist somit kostengünstig herstellbar.

Ein Schenkelverbindungsabschnitt einer erfindungsgemäßen Montagevorrichtung kann ein separates verbindbares Teil sein.

Der Schenkelverbindungsabschnitt kann aus einem entsprechend geformten Abschnitt eines ersten Schenkels und eines passend dazu geformten Abschnittes eines weiteren Schenkels gebildet werden.

Ein Schenkelverbindungsabschnitt kann formschlüssig wirken, indem beispielsweise zwei Bauteile, wie zwei Schenkel, puzzleartig miteinander koppelbar sind. Denkbar ist auch eine Koppelfläche, die, betrachtet aus der Displaynormalenrichtung, eine meanderförmige T-Form bildet.

Ein Schenkelverbindungsabschnitt kann kraftschlüssig wirken, wie mittels einem Druckknopfverschluss oder einem Klettverschluss, kann magnetisch wirken oder mittels Klebeflächen realisiert sein.

Beispielswese kann der Schenkelverbindungsabschnitt so gestaltet sein, dass ein Schenkel in einem Bereich nur die Hälfte seiner Dicke in Displaynormalenrichtung aufweist und ein weiterer Schenkel in einem Bereich die Hälfte seiner Dicke entgegen der Displaynormalenrichtung. Die beiden Schenkel haben auf den Bereichen die in der Dicke reduziert sind, Klebeflächen, so dass die beiden Schenkel mittels den Klebeflächen aneinandergefügt werden und dabei eine einheitliche Dicke des Anlageelementes im gesamten Schenkelverbindungsbereich entsteht.

Außerdem kann der Schenkelverbindungsabschnitt so gestaltet sein, dass er Rastenelemente und Achsausrichtungselemente vorsieht. Über die Achsausrichtungselemente werden zwei Schenkel bezüglich einer gemeinsamen Achse gekoppelt. Die beiden Schenkel können sich relativ zueinander um die gemeinsame Achse drehen. Die Rastenelemente können separat von den Achsanlageelementen so gekoppelt werden, dass sie die Drehung der beiden Schenkel um die gemeinsame Achse sperren können. Dadurch kann ein Winkel von Schenkeln zueinander und von Ausrichtabschnitten bzw. Positionierabschnitten zueinander variabel eingestellt werden und die Montagevorrichtung ist vielseitig für verschiedene Geräte- bzw. Displayformen nutzbar.

Eine Höhe eines Positionierelements einer erfindungsgemäßen Montagevorrichtung kann in Plattendickenrichtung so eingestellt sein, dass das Positionierelement den Untergrund nicht berührt, wenn das Gerät mit dem Positionierelement positioniert ist.

Die Verwendung der erfindungsgemäßen Montagevorrichtung kann folgende Reihenfolge haben: Zunächst wird ein Gerät auf einem Untergrund positioniert. Anschließend wird die Montagevorrichtung so an dem Gerät positioniert, dass die Positionierabschnitte der Positionierbauteile die dafür vorgesehenen Stellen des Gerätes berühren. Dabei zeigen die Positionierelemente aus dem Anlageelement in einer Schwerkraftrichtung nach unten. Der Auflageabschnitt liegt auf dem Display und/oder dem Gerät auf.

Für ein einwandfreies Fügen des Displayschutzes an das Display kann es notwendig sein, dass der Auflageabschnitt nicht von dem Display und/oder dem Gerät abhebt.

Zu diesem Zweck wird die Höhe des Positionierelementes so eingestellt, dass es den Untergrund nicht berührt, wenn das Gerät mit der Montagevorrichtung positioniert ist, da der Auflageabschnitt sonst von dem Display und/oder Gerät abheben könnte. Dadurch wird ein Fügen mit hoher Genauigkeit unterstützt.

Die Dicke eines Anlageelements einer erfindungsgemäßen Montagevorrichtung kann so vorgesehen sein, dass das Anlageelement den Untergrund nicht berührt, wenn das Gerät mit dem Anlageelement positioniert ist.

Die Verwendung der erfindungsgemäßen Montagevorrichtung kann folgende Reihenfolge haben: Zunächst wird ein Gerät auf einem Untergrund positioniert. Anschließend wird die Montagevorrichtung so an dem Gerät positioniert, dass die Ausrichtabschnitte des Anlageelementes die dafür vorgesehenen Stellen des Gerätes und/oder des Displays berühren. Dabei zeigen die Positionierelemente aus dem Anlageelement in einer Schwerkraftrichtung nach oben. Der Auflageabschnitt liegt auf dem Display und/oder dem Gerät auf.

Für ein einwandfreies Fügen des Displayschutzes an das Display kann es notwendig sein, dass der Auflageabschnitt nicht von dem Display und/oder dem Gerät abhebt.

Zu diesem Zweck wird die Dicke des Anlageelementes so vorgesehen, dass es den Untergrund nicht berührt, wenn das Gerät mit der Montagevorrichtung positioniert ist, da der Auflageabschnitt sonst von dem Display und/oder Gerät abheben könnte. Dadurch wird ein Fügen mit hoher Genauigkeit unterstützt. Anders ausgedrückt, ist die Dicke des Anlageelementes dünner als das Gerät.

Ein Positionierbauteil einer erfindungsgemäßen Montagevorrichtung kann so gestaltet sein, dass es in einem Koppelabschnitt senkrecht zu der Fügefläche verschieblich ist. Außerdem kann das Positionierbauteil auf einer einem Unterrund zugewandten Seite mit einem Haftelement versehen sein, mit dem das Positionierbauteil so auf dem Untergrund positionierbar ist, dass das Positionierbauteil auf dem Untergrund haftet und das Display und/oder das Gerät den Auflageabschnitt berühren.

Durch die Verschieblichkeit der Positionierbauteile senkrecht zur Fügefläche kann variabel eingestellt werden, wie weit die Positionierbauteile in einer Schwerkraftrichtung nach unten vorstehen, wenn das Gerät mit der Montagevorrichtung positioniert ist. Es kann somit sichergestellt werden, dass die Positionierbauteile den Untergrund nicht berühren und somit der Auflageabschnitt nicht von dem Gerät und/oder dem Display abhebt, selbst wenn die Positionierbauteile den Untergrund berühren. Eine überschüssige Länge der Positionierelemente steht dann in einer Schwerkraftrichtung von dem Anlageelement nach oben hin vor.

Beispielsweise können in dem Anlageelement Schlitze vorgesehen sein und Positionierbauteile können Stege aufweisen.

Wenn der Steg etwas breiter ist als der Schlitz, kann der Steg in dem Schlitz mittels Reibschluss befestigt werden. Dabei hängt das Übermaß, um wie viel der Steg breiter sein muss, als der Schlitz von den Werkstoffeigenschaften der Positionierbauteile ab. Wird ein Metallmaterial verwendet, das einen großen E-modul hat, sind einige 1/1000 mm für das Übermaß ausreichend. Wird ein Material verwendet, das einen geringen E-Modul hat, wie z.B. Pappe, MDF, HDF, Sperrholz, etc. oder ein Materialmix, sind einige 1/100 mm für das Übermaß ausreichend.

Berührt eine Seite eines Positionierbauteiles den Untergrund und ist auf dieser Seite ein Haftelement vorgesehen, haftet die Montagevorrichtung mittels der Haftelemente auf der Unterseite der Positionierelemente an dem Untergrund. Das hat den Vorteil, dass selbst unter äußerer Krafteinwirkung oder einer Kraftwirkung, die während dem Fügen entsteht, die Montagevorrichtung nicht relativ zu dem Untergrund verrutscht. Dadurch wird ein Fügen mit hoher Präzision unterstützt.

Auf einer dem Untergrund zugewandten Seite des Anlageelementes einer erfindungsgemäßen Montagevorrichtung kann ein Haftelement angeordnet sein, mit dem das Anlageelement so auf dem Untergrund positionierbar ist, dass das Anlageelement mit dem Haftelement auf dem Untergrund haftet und das Display und/oder das Gerät den Auflageabschnitt berühren.

Das hat den Vorteil, dass selbst unter äußerer Krafteinwirkung oder einer Kraftwirkung, die während dem Fügen entsteht, die Montagevorrichtung nicht relativ zu dem Untergrund verrutscht. Dadurch wird ein Fügen mit hoher Präzision unterstützt.

Beispielsweise kann die Haftauflage aus Gummi hergestellt sein. Alternativ kann die Haftauflage aus einem doppelseitigen Klebeband bestehen, das auf beiden Klebeseiten Abdeckungen aufweist.

Das Anlageelement einer erfindungsgemäßen Montagevorrichtung kann eine Plattenform haben und die eine Seite kann eine Plattenoberseite und die andere Seite eine Plattenunterseite sein.

Durch die Plattenform ist es möglich, das Anlageelement der Montagevorrichtung ohne aufwändige Form herzustellen, wie es beispielsweise beim Kunststoffdruckguss nötig ist. Das reduziert die Herstellungskosten.

Als Material für einen plattenförmigen Rohling kommen beispielsweise Pappe, MDF, HDF, Sperrholz, etc. oder ein Materialmix in Betracht. Es können biologisch abbaubare, nachwachsende oder recycelbare Rohstoffe verwendet werden. Es sind alle stabilen Flachmaterialien geeignet.

Die Oberfläche des Anlageelements und des Rohlings kann Stufen oder Wellen oder eine sonstige Oberflächenstruktur aufweisen, es kann eine einheitliche Dicke oder aber bereichsweise unterschiedliche Dicken aufweisen. Solche Elemente der Oberflächenstruktur können beispielsweise als Aussparung verwendet werden. Außerdem kann es solch eine Oberflächenstruktur dem Anwender erleichtern, das Anlageelement zu greifen und verbessert somit die Handhabbarkeit der Montagevorrichtung. Auch die Festigkeit kann durch eine geeignete Oberflächenstruktur erhöht werden.

Die Dicke für die Plattenform kann beispielsweise im Bereich von 0.8 mm und 5 mm liegen, vorzugsweise zwischen 1.5 und 2.5 mm. Die Dicke des Materials kann sich an den Materialeigenschaften orientieren. So können Materialien mit einer hohen Festigkeit dünner ausgeführt sein und Materialien mit einer niedrigen Festigkeit können tendenziell dicker ausgeführt sein. Dadurch ist die Herstellung auf einfache Weise möglich. Beispielsweise muss weniger Energie für die Herstellung des Anlageelements mittels Laserschneiden aufgewendet werden, wenn die Dicke des Rohlings gering ist. Somit kann das Anlageelement kostengünstig, energieeffizient, ökonomisch und ökologisch hergestellt werden.

Außerdem kann somit sichergestellt werden, dass die Montagevorrichtung eine hinreichende Steifigkeit aufweist, so dass relevante Ausrichtabschnitte und Positionierabschnitte während dem Fügen relativ zueinander positioniert bleiben. Dadurch wird ein Fügen mit hoher Präzision ermöglicht.

Außerdem weist eine plattenförmige Gestaltung den Vorteil auf, dass die Anlageelemente einen geringen Raumbedarf aufweisen, wodurch Transport- und Lagerkosten reduziert werden können.

Außerdem können die Montagevorrichtungen durch die Plattenform so hergestellt werden, dass sie leicht sind. Dadurch können Transportkosten und eine daraus resultierende Umweltbelastung reduziert werden.

Die Montagevorrichtung kann dem Anwender als Bausatz oder als fertig aufgebaute Montagevorrichtung bereitgestellt werden.

Ein Rahmenkoppelabschnitt einer erfindungsgemäßen Montagevorrichtung kann aus einer länglichen in Plattendickenrichtung durchgängigen Aussparung bestehen und mit dem Koppelabschnitt des Positionierbauteils koppelbar sein.

Dies ermöglicht ein Herstellverfahren wie Stanzen, Laserstrahlschneiden, Wasserstrahlschneiden oder der Gleichen. Somit kann eine Montagevorrichtung kostengünstig hergestellt werden.

Ein Bereich auf der Plattenunterseite des Anlageelements einer erfindungsgemäßen Montagevorrichtung kann als Anschlag dienen, der die Bewegung eines Positionierbauteils in der Plattendickenrichtung einschränkt.

Dieser Bereich kann die Plattenunterseite sein. Dieser Bereich kann aber auch in Plattendickenrichtung auf der Plattenunterseite vorspringen bzw. vertieft sein.

Die Gestaltung mit einem Anschlag für das Positionierbauteil erleichtert dem Anwender einen Zusammenbau der Montagevorrichtung.

Ein Anlageelement einer erfindungsgemäßen Montagevorrichtung kann zusätzlich einen plattenförmigen Koppelverschluss haben, der mittels zumindest einem Steg mit dem Anlageelement in dem Rahmenkoppelabschnitt verbunden ist.

Das hat den Vorteil, dass der Rahmenkoppelabschnitt vor einer Verunreinigung geschützt ist, bis der Koppelverschluss aus dem Anlageelement gelöst wird. Somit wird die Funktion der Montagevorrichtung sichergestellt.

Ein plattenförmiges Positionierbauteil einer erfindungsgemäßen Montagevorrichtung kann mittels zumindest einem Steg mit dem Anlageelement verbunden sein.

Beispielsweise kann das Positionierbauteil in einem Bereich angeordnet sein, der von den Schenkeln umgeben ist. Im Falle einer L-Form des Anlageelementes kann ein Positionierbauteil in dem von den Schenkeln aufgespannten Bereich angeordnet sein. Im Falle einer U-Form des Anlageelementes kann ein Positionierbauteil innerhalb der U-Form angeordnet sein.

Dadurch kann Material für die Herstellung der Montagevorrichtung reduziert werden und die Montagevorrichtung ist kostengünstig und ressourcenschonend herstellbar. Außerdem kann die Montagevorrichtung platzsparend und in Stapeln gelagert werden.

Wenn die Schenkel voneinander separate Bauteile sind, die mit Schenkelverbindungsabschnitten verbunden werden, können Positionierbauteile in der Verlängerung der Schenkel angeordnet sein und die Schenkel sind parallel zueinander angeordnet und miteinander mit zumindest einem Steg verbunden. Alternativ können die Schenkel in diesem Fall auch parallel zueinander angeordnet sein und Positionierbauteile können zwischen ihnen angeordnet sein, wobei Schenkel mit Positionierbauteilen mittels zumindest einem Steg verbunden sein können.

Es können auch Positionierbauteile mittels zumindest einem Steg miteinander verbunden sein.

Ein Positionierbauteil kann in einem Bereich angeordnet sein, der zwischen anliegenden Stellen eines Ausrichtabschnittes zurückgenommen ist, der einen Abstand zu dem Gerät oder dem Displayschutz aufweist. Somit kann das benötigte Material zur Herstellung der Montagevorrichtung reduziert werden.

Eine Mittelplatte kann in einer erfindungsgemäßen Montagevorrichtung mittels einem Steg mit dem Anlageelement verbunden sein.

Dabei ist die Mittelplatte vorzugsweise in einem Bereich angeordnet, der von den Schenkeln des Anlageelements umgeben ist. Im Falle einer L-Form des Anlageelementes kann ein Mittelbauteil in dem von den Schenkeln aufgespannten Bereich angeordnet sein. Im Falle einer U-Form des Anlageelementes kann ein Mittelelement innerhalb der U-Form angeordnet sein.

Die Mittelplatte kann auch auf beiden Seiten mit Haftelementen versehen sein. In diesem Fall dient die Mittelplatte als Haftauflage.

Ein Positionierbauteil einer erfindungsgemäßen Montagevorrichtung kann mittels zumindest einem Steg mit der Mittelplatte verbunden sein.

Ein Positionierbauteil ist in diesem Fall vorzugsweise innerhalb der Mittelplatte angeordnet.

Wenn viele Stützbauteile oder weitere Bauteile für die Montagevorrichtung benötigt werden, können Stützbauteile auch außerhalb der Mittelplatte und außerhalb des Anlageelementes angeordnet sein.

Dadurch kann Material für die Herstellung der Montagevorrichtung reduziert werden und die Montagevorrichtung ist kostengünstig und ressourcenschonend herstellbar. Außerdem kann die Montagevorrichtung platzsparend und in Stapeln gelagert werden. Außerdem können die Einzelteile der Montagevorrichtung für einen Transport stabil gestaltet sein und eine Beschädigung der Einzelteile der Montagevorrichtung während dem Transport kann verhindert werden.

Ein innerhalb der Mittelplatte angeordnetes Abstreichelement kann in einer erfindungsgemäßen Montagevorrichtung mittels zumindest einem Steg mit der Mittelplatte verbunden sein.

Das Abstreichelement dient dazu, während oder nach einem Fügen eines Displayschutzes auf ein Display, mit Druck in Richtung des Displayschutzes über den Displayschutz zu streichen. Dadurch werden Luftblasen, die sich während des Fügens zwischen dem Displayschutz und dem Display gebildet haben, zu einer Außenseite befördert und zwischen dem Displayschutz und dem Display entfernt.

Zumindest ein Positionierbauteil einer erfindungsgemäßen Montagevorrichtung kann mittels einem Steg innerhalb des Abstreichelementes mit dem Abstreichelement verbunden sein.

Das Abstreichelement einer erfindungsgemäßen Montagevorrichtung kann so in der Mittelplatte positioniert sein, dass es einen entgegen der Displaynormalenrichtung vorstehenden Bereich des Geräts auf einer Unterseite des Geräts überdeckt, wenn das Gerät mit dem Anlageelement positioniert ist.

Der vorstehende Bereich des Geräts kann eine Kamera, ein Fingerabdrucksensor, eine Taste oder der Gleichen sein.

Wird das Abstreichelement in der Mittelplatte an diesem Bereich angeordnet, kann die Mittelplatte nach Herauslösen des Abstreichelements als Positionierhilfe dienen. Wird das Gerät entsprechend auf die Mittelplatte aufgelegt, ist die Oberseite des Gerätes und das Display des Gerätes trotz vorstehender Bereiche des Gerätes stabil und parallel zu dem Untergrund orientiert. Das vereinfacht ein präzises Fügen.

Ein innerhalb der Mittelplatte angeordnetes Geräthalteelement kann in einer erfindungsgemäßen Montagevorrichtung mittels zumindest einem Steg mit der Mittelplatte verbunden sein.

Es wird somit Restmaterial verwendet, um ein Geräthalteelement bereitzustellen. Dadurch, dass die Herstellung eines separaten Geräthalteelementes entfällt trägt die Montagevorrichtung zu einer Schonung der Ressourcen bei.

Mittels dem Geräthalteelemente kann das Gerät auf einem Untergrund so abgestellt werden, dass ein Anwender, vor dem das Gerät abgestellt ist, das Display gut sehen kann, ohne das Gerät selbst halten zu müssen.

Das Geräthalteelement kann beispielsweise dazu dienen, das Gerät auf einem ebenen Untergrund in einen bestimmten Winkel relativ zu dem Untergrund zu halten. Beispielsweise ist dieser Winkel im Bereich von 50° bis 80°. In diesem Winkelbereich nimmt das Gerät eingesetzt in das Geräthalteelement eine für die Blickrichtung des Anwenders ergonomische Ausrichtung ein.

Die Breite eines Steges ist vorzugsweise 0.1 mm bis 1 mm. Die Breite der Stege ist vorzugsweise so gestaltet, dass sich die Koppelverschlüsse mittels einer Handkraft aus dem Anlageelement lösen lässt. Insofern hängt die Breite der Stege stark von dem Material des Rohteils des Anlageelements, von der Dicke des Rohteils und von der Anzahl an Stegen ab, mit denen der Koppelverschluss mit dem Anlageelement verbunden ist. Die Breite eines Steges bzw. die Anzahl an Stegen hängt aber auch von der Größe des Bauteils ab, das mit den Stegen befestigt ist.

Beispielsweise weist ein Koppelverschlusselement eine geringe Anzahl an Stegen auf, wohingegen eine Mittelplatte oder ein Abstreichelement mehr Stege oder dickere Stege aufweisen, da sie größer sind als die Koppelverschlusselemente und bei gleicher Flächenpressung eine größere Auspresskraft auf sie ausgeübt werden kann.

Dadurch kann Material für die Herstellung der Montagevorrichtung reduziert werden und die Montagevorrichtung ist kostengünstig und ressourcenschonend herstellbar. Außerdem kann die Montagevorrichtung platzsparend und in Stapeln gelagert werden. Außerdem können die Einzelteile der Montagevorrichtung für einen Transport stabil gestaltet sein und eine Beschädigung der Einzelteile der Montagevorrichtung während dem Transport kann verhindert werden.

Ein Positionierabschnitt einer erfindungsgemäßen Montagevorrichtung kann Bedienelementaussparungen haben, die in einer Richtung parallel zu der Fügefläche vorstehende Bereiche des Geräts oder des Displays freilegen.

Dadurch kann sichergestellt werden, dass die Displayausrichtabschnitte nicht an vorstehenden Bereichen des Geräts, wie beispielsweise Knöpfen oder anderen Bedienelementen, oder des Displays hängen bleiben, wenn die Montagevorrichtung auf das Gerät, bzw. Display aufgesetzt wird. Somit wird ein Fügen mit hoher Präzision ermöglicht

Das Anlageelement einer erfindungsgemäßen Montagevorrichtung kann einen Beschriftungsbereich haben.

Der Beschriftungsbereich kann der Aufprägung einer Identifikationsnummer dienen. Sollte in der Produktion eine Fehlstelle, beispielsweise eine Spitze oder scharfkantige Stelle, in Montagevorrichtungen entstehen, die für den Anwender gefährlich werden können, können die betroffenen Montagevorrichtungen leicht identifiziert und aus dem Umlauf genommen werden. Dadurch wird eine sichere Handhabung der Montagevorrichtung unterstützt.

Der Beschriftungsbereich kann beispielsweise auch in einem Positionierbauteil, einem Griffabschnitt, einer Mittelplatte, einem Abstreichelement oder einem Gerätehalteelement vorgesehen sein.

Der Beschriftungsbereich kann bezüglich der ihn umgebenden Fläche vertieft oder vorstehend sein.

### Kurze Beschreibung der Zeichnungen

Fig. 1 zeigt eine erste Ausführungsform einer erfindungsgemäßen Montagevorrichtung perspektivisch.
Fig. 2a bis 2c zeigen unterschiedliche Varianten von Positionierbauteilen der ersten Ausführungsform der erfindungsgemäßen Montagevorrichtung.
Fig. 3 zeigt einen anfänglichen Montageschritt bei Verwendung der ersten Ausführungsform der erfindungsgemäßen Montagevorrichtung.
Fig. 4 zeigt einen weiteren Montageschritt bei Verwendung der ersten Ausführungsform der erfindungsgemäßen Montagevorrichtung.
Fig. 5 zeigt einen weiteren Montageschritt bei Verwendung der ersten Ausführungsform der erfindungsgemäßen Montagevorrichtung.
Fig. 6 zeigt eine alternative Anwendung der ersten Ausführungsform der erfindungsgemäßen Montagevorrichtung.
Fig. 7 zeigt einen anfänglichen Montageschritt bei Verwendung einer zweiten Ausführungsform der erfindungsgemäßen Montagevorrichtung.
Fig. 8 zeigt einen weiteren Montageschritt bei Verwendung der zweiten Ausführungsform der erfindungsgemäßen Montagevorrichtung.
Fig. 9 zweigt einen weiteren Montageschritt bei Verwendung der zweiten Ausführungsform der erfindungsgemäßen Montagevorrichtung.
Fig. 10 zeigt eine dritte Ausführungsform der erfindungsgemäßen Montagevorrichtung perspektivisch.
Fig. 11 zeigt einen anfänglichen Montageschritt bei Verwendung der dritten Ausführungsform der erfindungsgemäßen Montagevorrichtung.
Fig. 12 zeigt einen weiteren Montageschritt bei Verwendung der dritten Ausführungsform der erfindungsgemäßen Montagevorrichtung.
Fig. 13 zeigt einen weiteren Montageschritt bei Verwendung der dritten Ausführungsform der erfindungsgemäßen Montagevorrichtung.
Fig. 14 zeigt eine vierte Ausführungsform der erfindungsgemäßen Montagevorrichtung perspektivisch.
Fig. 15 zeigt einen anfänglichen Montageschritt bei Verwendung der vierten Ausführungsform der erfindungsgemäßen Montagevorrichtung.
Fig. 16 zeigt einen weiteren Montageschritt bei Verwendung der vierten Ausführungsform der erfindungsgemäßen Montagevorrichtung.
Fig. 17 zeigt einen weiteren Montageschritt bei Verwendung der vierten Ausführungsform der erfindungsgemäßen Montagevorrichtung.
Fig. 18 zeigt eine fünfte Ausführungsform der erfindungsgemäßen Montagevorrichtung perspektivisch.
Fig. 19 zeigt einen anfänglichen Montageschritt bei Verwendung der fünften Ausführungsform der erfindungsgemäßen Montagevorrichtung.
Fig. 20 zeigt einen weiteren Montageschritt bei Verwendung der fünften Ausführungsform der erfindungsgemäßen Montagevorrichtung.

### Ausführliche Beschreibung der Ausführungsformen

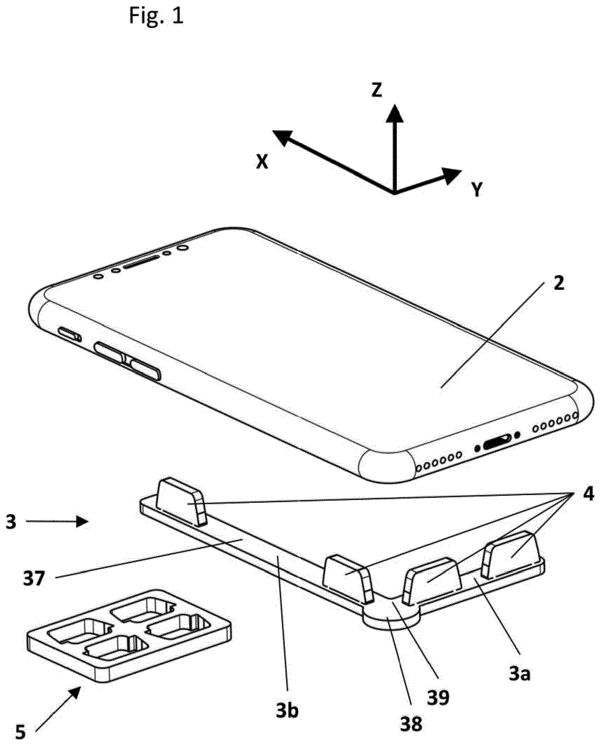

Fig. 1 zeigt eine erste Ausführungsform der erfindungsgemäßen Montagevorrichtung, die für ein Smartphone verwendet wird. Die Montagvorrichtung besteht aus einem L-förmigen Anlageelement 3. Das Anlageelement 3 hat zwei Schenkel 3a, 3b, die senkrecht zueinander stehen. Der erste Schenkel 3a weist in die Querrichtung Y, der zweite Schenkel 2b weist in die Längsrichtung X. Je zwei Positionierbauteile 4 sind an den ersten und zweiten Schenkel 3a und 3b gekoppelt. Die Positionierbauteile 4 stehen von dem Anlageelement in Displaynormalenrichtung Z vor. Die Schenkel 3a, 3b sind mittels dem Schenkelverbindungsabschnitt 39 verbunden.

Der Schenkelverbindungsabschnitt 39 weist einen zylinderförmigen Griffabschnitt 38 auf. Der Griffabschnitt 38 bietet dem Anwender einen Bereich, der gut zu greifen ist. Somit kann der Anwender die Montagevorrichtung mittels dem Griffabschnitt 38 leicht positionieren.

In der vorliegenden Ausführungsform bildet die Fläche des Anlageelements 3, die in Displaynormalenrichtung Z weist, einen Auflageabschnitt 37. Auf den Auflageabschnitt kann das Gerät mit Display 2 gelegt werden.

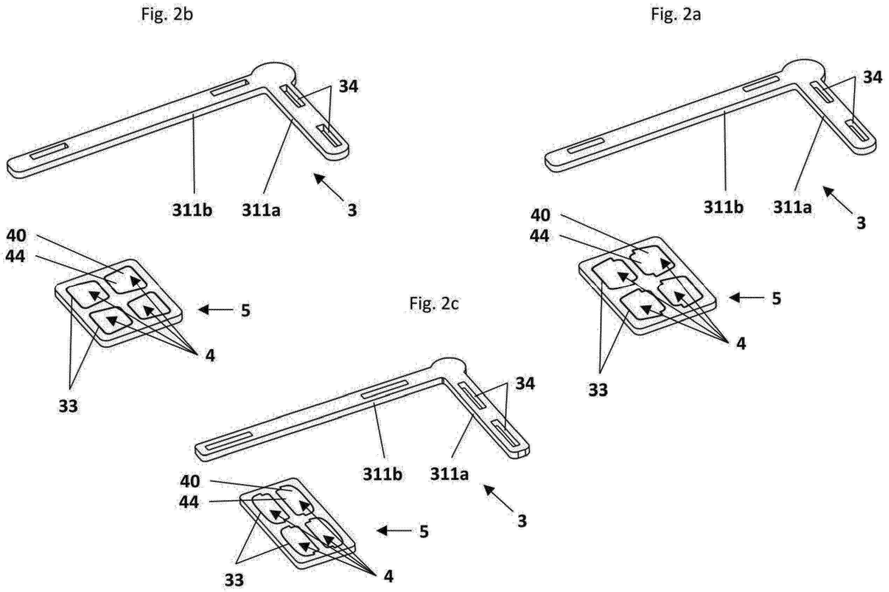

Die Positionierbauteile 4 weisen auf den Seiten, die dem Gerät zugewandt sind, jeweils einen Positionierabschnitt 40 auf (siehe Figuren 2a bis 2c). Das Gerät kann mit seinen Seitenflächen entgegen der Längsrichtung X und entgegen der Querrichtung Y in Kontakt mit den Positionierabschnitten 40 gebracht werden. Außerdem kann ein Displayschutz 1 mit den Positionierabschnitten 40 in Kontakt gebracht werden. Alternativ kann der Displayschutz 1 mit den Ausrichtabschnitten 311a, 311b auf den Seiten der Schenkel, die dem Gerät zugewandt sind, in Kontakt gebracht werden.

Ferner kann der Displayschutz 1 an dem Display 2 des Gerätes positioniert werden. Somit können Displayschutz 1 und Display 2 des Geräts mittels der Montagevorrichtung bezüglich allen drei Raumrichtungen eindeutig relativ zueinander positioniert werden.

In einem Ausgangszustand sind die Positionierbauteile 4 in entsprechenden Aussparungen eines Abstreichelements 5 vorgesehen. Dabei sind die Positionierbauteile 4 mit Stegen 33 an dem Abstreichelement 5 angebunden. Das Abstreichelement 5 ist an den Ausrichtabschnitten 311a, 311b des Anlageelementes 3 mittels Stegen 33 verbunden.

Betrachtet aus der Displaynormalenrichtung Z, ist der Radius der Ecken des Abstreichelements 5 kleiner als der Radius des Schenkelverbindungsabschnitts 39 in der X-Y-Richtung. Dadurch kann das Abstreichelement 5 in dem Ausgangszustand nahe an dem Schenkelverbindungsabschnitt 39 positioniert sein. Die Bauteile Positionierbauteil 4, Abstreichelement 5 und Anlageelement 3 weisen eine Plattenform auf mit jeweils der gleichen Dicke. Die Stege 33 sind so gestaltet, dass man sie mittels Handkraft durchtrennen kann. Somit sind Positionierbauteil 4, Abstreichelement 5 und Anlageelement 3 leicht voneinander trennbar.

Fig. 2a bis 2c zeigen unterschiedliche Varianten von Positionierbauteilen 4, die jeweils mittels Stengen 33 in einem Abstreichelement 5 vorgesehen sind. Jedes Positionierbauteil 4 weist einen Koppelabschnitt 44 und einen Positionierabschnitt 40 auf.

Jeder Schenkel 3a, 3b des Anlageelements 3 weißt zwei Rahmenkoppelabschnitte 34 auf. Die Rahmenkoppelabschnitte 34 sind rechteckige Durchgangslöcher, deren Breite der Dicke der Platte entspricht, aus der das Anlageelement 3, die Positionierbauteile 4 und das Abstreichelement 5 hergestellt sind. Die Rahmenkoppelabschnitte 34 sind an jedem Schenkel 34 so angeordnet, dass sie einen möglichst großen Abstand zueinander aufweisen.

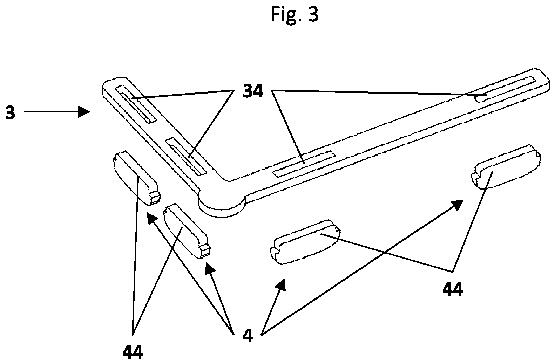

Wie in Fig. 3 dargestellt, kann ein Koppelabschnitt 40 eines Positionierbauteiles 4 in einen Rahmenkoppelabschnitt 34 eines Anlageelements 3 eingeschoben werden, bis der Positionierabschnitt 40 an das Anlageelement 3 anstößt. Somit kann ein Positionierbauteil 4 mit dem Anlageelement 3 gekoppelt werden.

Jeder Schenkel 3a, 3b weist einen Ausrichtabschnitt 311a, 311b auf. Die Ausrichtabschnitte 311a, 311b sind senkrecht zueinander. Die Ausrichtabschnitte 311a, 311b sind mit einem Radius miteinander verbunden, der, betrachtet aus der Displaynormalenrichtung Z, kleiner ist als ein entsprechender Radius einer Ecke eines Geräts, Displays 2 oder Displayschutzes 1.

Der Positionierabschnitt 40 kann mit dem Gerät bzw. Display 2 oder dem Displayschutz 1 in Kontakt gebracht werden, wenn das Positionierbauteil 4 und das Anlageelement 3 miteinander gekoppelt sind. Dementsprechend kann ein Ausrichtabschnitt 311a, 311b mit dem Displayschutz 1 oder dem Gerät bzw. Display 2 in Kontakt gebracht werden.

Das Positionierelement 4 aus Fig. 2a ist mit einer Schulter zwischen dem Koppelabschnitt 44 und dem Positionierabschnitt 40 versehen. Die Schulter steht an dem Ausrichtelement 3 an, wenn das Positionierbauteil 4 mit dem Ausrichtelement 3 gekoppelt ist. Eine Höhe des Positionierabschnitts 40 ist größer, als eine Dicke des Geräts in Displaynormalenrichtung Z.

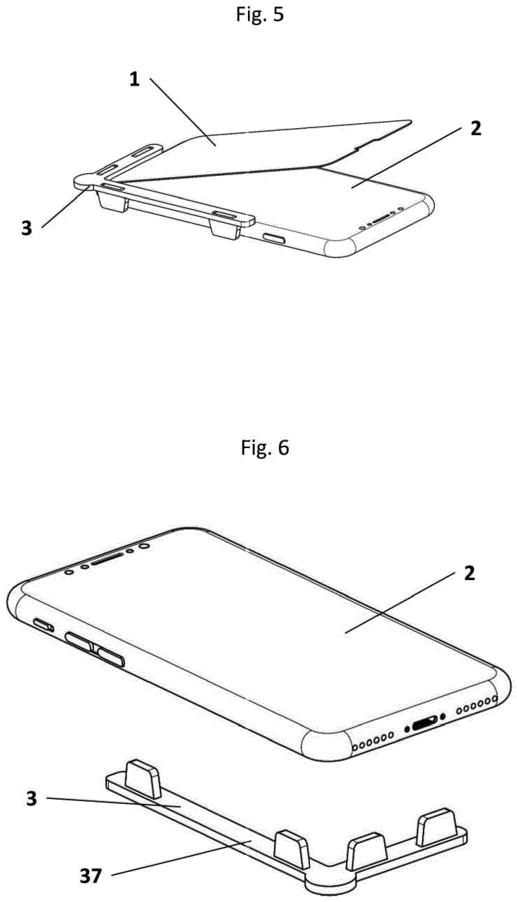

Somit kann, wie in Fig. 6 dargestellt ist, die Montagevorrichtung aus Fig. 2a in Displaynormalenrichtung Z unter dem Gerät positioniert werden. Dabei überragen die Positionierabschnitte 40 das Gerät in Displaynormalenrichtung Z und die Positionierabschnitte 40 berühren das Gerät auf einer Seite, die in eine Richtung senkrecht zu der Displaynormalenrichtung Z weist. Ferner kann ein Displayschutz 1 ebenfalls in Kontakt mit den Positionierabschnitten 40 gebracht werden, während es mit dem Display 2 des Geräts in Kontakt gebracht wird.

Das Positionierelement 4 aus Fig. 2b weist keine Schulter auf. Jedoch ist das Positionierbauteil 4 in Richtung des Koppelabschnitts 44 schmal zulaufend, so dass der Positionierabschnitt 40 wesentlich breiter ist, als der Koppelabschnitt 44. Die Länge eines Rahmenkoppelabschnitts 34 des Anlageelements 3 ist exakt an eine Breite des Positionierbauteils 4 angepasst, so dass die sich verjüngenden Seiten des Positionierbauteils 4 an einer bestimmten Stelle an dem Anlageelement 3 anstoßen, wenn der Koppelabschnitt 44 in den Rahmenkoppelabschnitt 34 eingeschoben wird. Dadurch kann der Betrag bestimmt werden, um den der Positionierabschnitt 40 in Displaynormalenrichtung Z von dem Anlageelement 3 vorsteht, wenn ein Positionierelement 4 mit dem Anlageelement 3 gekoppelt ist.

Das Positionierelement 3 aus Fig. 2c weist eine Schulter auf. Eine Höhe des Positionierabschnitts 40 ist geringer als eine Dicke des Gerätes in Displaynormalenrichtung Z. Somit kann die Montagevorrichtung in Displaynormalenrichtung Z oben auf dem Gerät positioniert werden, ohne dass die Positionierelemente 4 einen ebenen Untergrund berühren, auf dem das Gerät aufliegt, wenn das Positionierelement 4 und das Anlageelement 3 gekoppelt sind.

Fig. 3 zeigt einen anfänglichen Montageschritt bei der Verwendung der ersten Ausführungsform. Demnach werden zunächst die Positionierelemente 4 mit dem Anlageelement 3 gekoppelt.

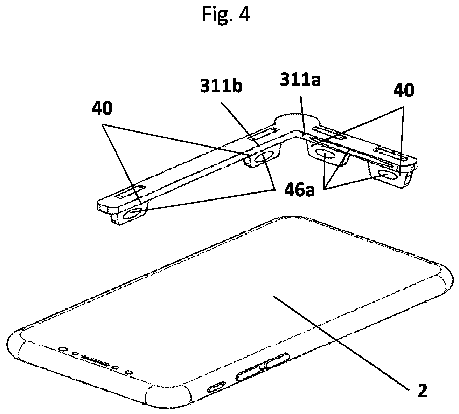

In Fig. 4 ist das Gerät mit dem Display nach oben in Displaynormalenrichtung Z auf einem ebenen Untergrund positioniert. Anschließend wird die Montagevorrichtung von oben mit dem Gerät in Kontakt gebracht.

Um einen Montagevorgang zu vereinfachen, sind an den Positionierabschnitten 40 Haftelemente 46a vorgesehen, die in Kontakt mit Seitenflächen des Geräts gebracht werden.

Wie in Fig. 5 dargestellt, haftet dadurch die Montagevorrichtung stabil an dem Gerät und behält seine Position zuverlässig bei. Der Anwender kann sich ganz auf das Positionieren des Displayschutzes an den Ausrichtabschnitten 311a, 311b konzentrieren.

An dem Ausrichtabschnitt 311a ist ebenfalls ein Haftelement 46a vorgesehen. Liegt der Displayschutz 1 an dem Ausrichtabschnitt 311a an, wie in Fig. 4 dargestellt, verhindert das Haftelement 46a eine Verschiebung des Displayschutzes 1 in Querrichtung Y und Längsrichtung X. Der Anwender kann sich ganz auf ein Schwenken des Displayschutzes um die Querrichtung Y konzentrieren, um den Displayschutz 1 an das Display 2 zu fügen.

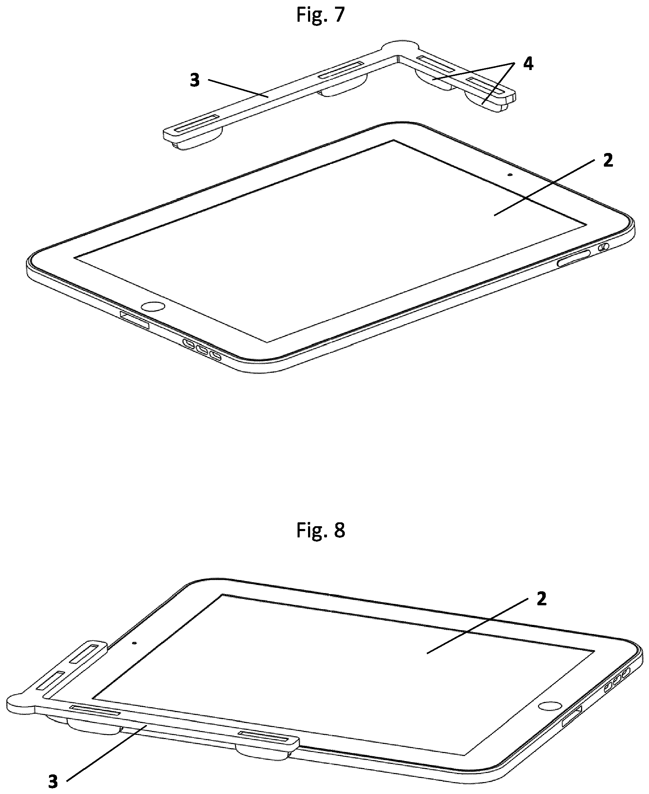

Fig. 7 zeigt eine zweite Ausführungsform einer erfindungsgemäßen Montagevorrichtung. In der vorliegenden Ausführungsform wird die Montagvorrichtung für ein Tablet mit großem Display verwendet. Zunächst werden vier Positionierelement 4 mit dem Anlageelement 3 gekoppelt.

In Fig. 8 ist gezeigt, wie das Anlageelement 3 in Displaynormalenrichtung Z auf dem Gerät positioniert wird, wobei die Positionierabschnitte 40 der Positionierelemente an benachbarten Seitenflächen des Geräts anliegen.

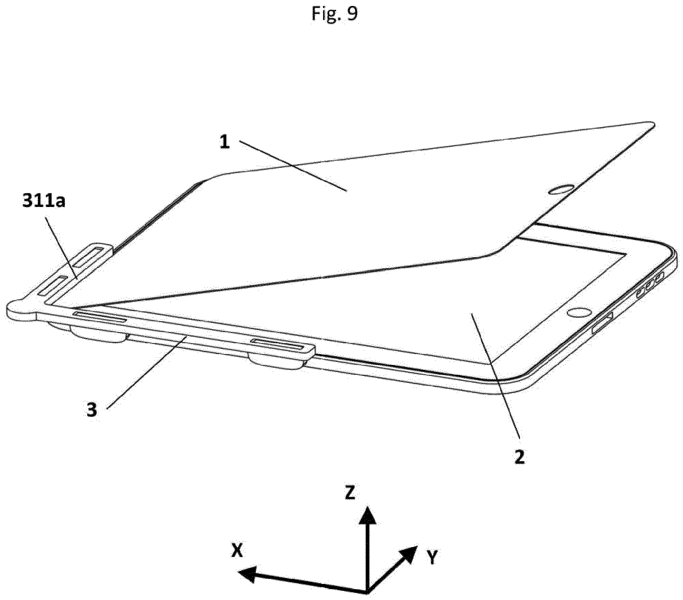

In Fig. 9 ist gezeigt, wie der Displayschutz 1 zunächst an dem ersten Ausrichtabschnitt 311a angelegt wird und anschließend um die Querrichtung Y geschwenkt wird, um an das Display 2 des Geräts gefügt zu werden.

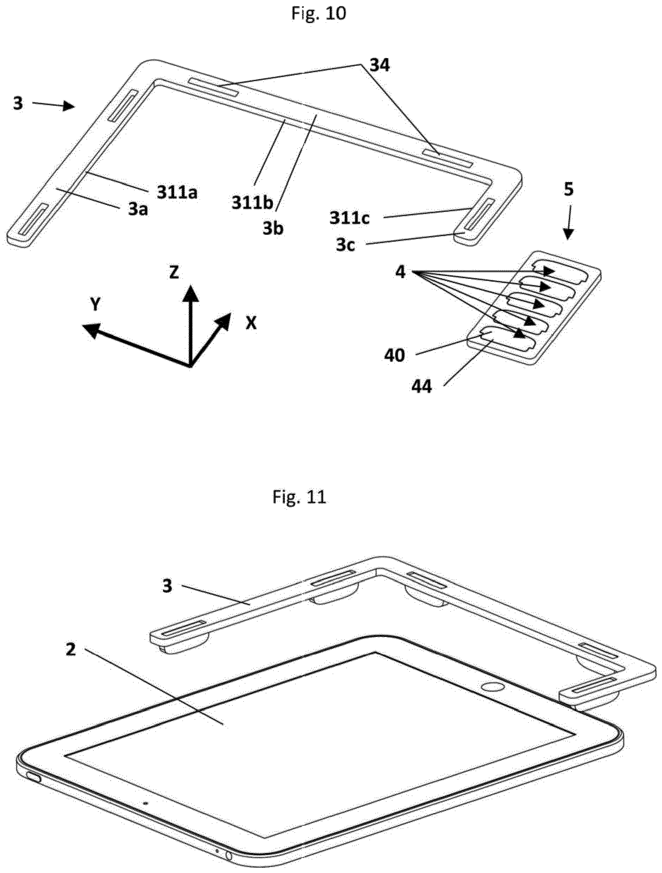

Fig. 10 zeigt eine dritte Ausführungsform einer erfindungsgemäßen Montagevorrichtung. In der dritten Ausführungsform besteht das Anlageelement 3 aus drei Schenkeln 3a, 3b, 3c. Der erste Schenkel 3a ist senkrecht zu dem zweiten Schenkel 3b orientiert. Der dritte Schenkel 3c ist senkrecht zu dem zweiten Schenkel 3b und parallel zu dem ersten Schenkel 3a orientiert. Der erste Schenkel 3a und der dritte Schenkel 3c weisen in die gleiche Richtung.

Die Länge des zweiten Schenkels 3b entspricht der Breite eines Geräts. Der erste Schenkel 3a weist eine wesentlich größere Länge als der dritte Schenkel 3c auf. Betrachtet aus der Displaynormalenrichtung Z ergibt sich somit für das Anlageelement 3 eine J-Form. Der erste Schenkel 3a und der zweite Schenkel 3b dienen der Positionierung der Montagevorrichtung an dem Gerät. Der Dritte Schenkel 3c verhindert eine Verschiebung der Montagevorrichtung in Querrichtung Y parallel zu dem zweiten Schenkel 3b.

Der erste und der zweite Schenkel 3a, 3b weisen jeweils zwei Rahmenkoppelabschnitte 34 auf. Der dritte Schenkel 3c weist einen Rahmenkoppelabschnitt 34 auf. Insgesamt sind somit fünf Positionierelemente 4 mit dem Anlageelement 3 koppelbar.

In einem Ausganszustand sind die fünf Positionierelemente 4 mittels Stegen 33 in einem Abstreichelement 5 vorgesehen.

Fig. 11 zeigt aus dem Abstreichelement 5 herausgelöste Positionierelemente 4, die an dem Anlageelement 3 gekoppelt sind. Die Montagevorrichtung wird auf das Gerät aus der Displaynormalenrichtung Z aufgelegt.

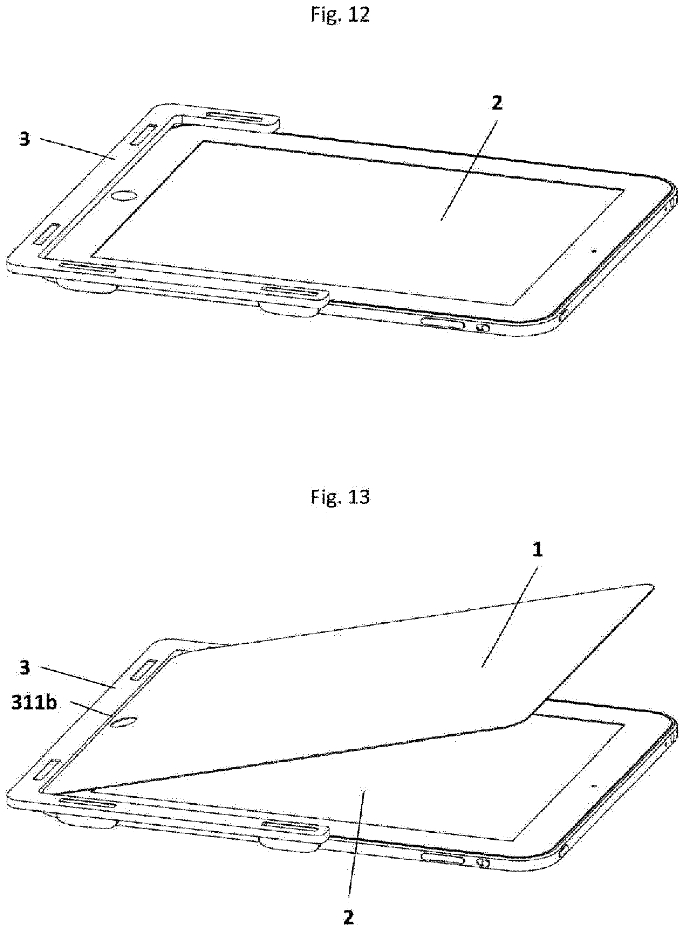

Fig. 12 zeigt das Anlageelement 3, das an dem Gerät mit Display 2 positioniert ist. In der vorliegenden Ausführungsform ist das Display 2 des Geräts so beschaffen, dass die Montagevorrichtung an beiden Seiten in Längsrichtung X an dem Gerät positioniert werden kann, um den Displayschutz 1 an das Display 2 zu fügen.

Fig. 13 zeigt den Displayschutz 1, der an dem zweiten Ausrichtabschnitt 311b und auf dem Display 2 anliegt. Mittels Schwenken des Displayschutzes 1 um die Querrichtung Y kann der Displayschutz 1 an das Display 2 gefügt werden.

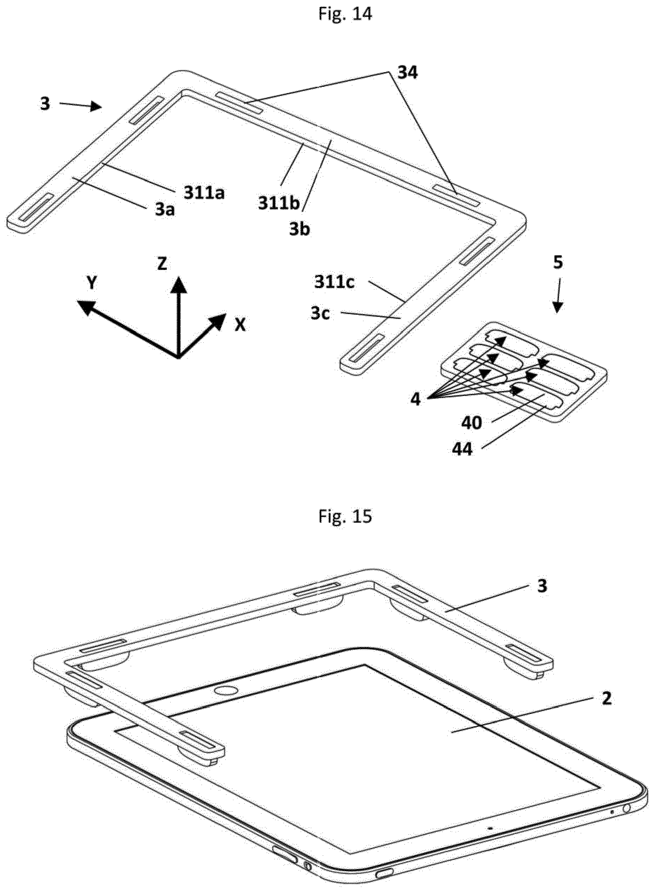

Fig. 14 zeigt eine vierte Ausführungsform einer erfindungsgemäßen Montagevorrichtung. In der vierten Ausführungsform besteht das Anlageelement 3 aus drei Schenkeln 3a, 3b, 3c. Der erste Schenkel 3a ist senkrecht zu dem zweiten Schenkel 3b orientiert. Der dritte Schenkel 3c ist senkrecht zu dem zweiten Schenkel 3b und parallel zu dem ersten Schenkel 3a orientiert. Der erste Schenkel 3a und der dritte Schenkel 3c weisen in gleiche Richtung.

Die Länge des zweiten Schenkels 3b entspricht einer Breite eines Geräts. Der erste Schenkel 3a und der dritte Schenkel 3c haben die gleiche Länge. Somit ergibt sich für das Anlageelement 3 eine U-Form. Der erste Schenkel 3a und der zweite Schenkel 3b dienen der Positionierung der Montagevorrichtung an dem Gerät. Der Dritte Schenkel 3c verhindert eine Verschiebung der Montagevorrichtung in Querrichtung Y parallel zu dem zweiten Schenkel 3b.

Alle Schenkel 3a, 3b, 3c weisen jeweils zwei Rahmenkoppelabschnitte 34 auf. Insgesamt sind somit sechs Positionierelemente 4 mit dem Anlageelement 3 koppelbar.

In einem Ausganszustand sind die sechs Positionierelemente 4 mittels Stegen 33 in einem Abstreichelement 5 vorgesehen.

Fig. 15 zeigt, die aus dem Abstreichelement 5 herausgelösten Positionierelemente 4, die an das Anlageelement 3 gekoppelt sind. Die Montagevorrichtung wird auf das Gerät aus der Displaynormalenrichtung Z aufgelegt.

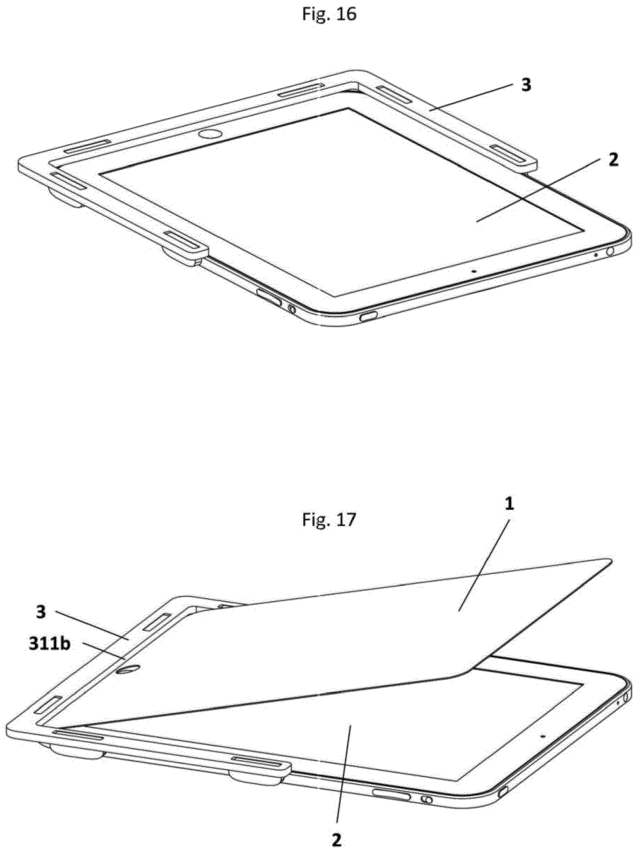

Fig. 16 zeigt das Anlageelement 3, das an dem Gerät mit Display 2 positioniert ist.

Fig. 17 zeigt den Displayschutz 1, der an dem zweiten Ausrichtabschnitt 311b und auf dem Display 2 anliegt. Mittels Schwenken des Displayschutzes 1 um die Querrichtung Y kann der Displayschutz 1 an das Display 2 gefügt werden.

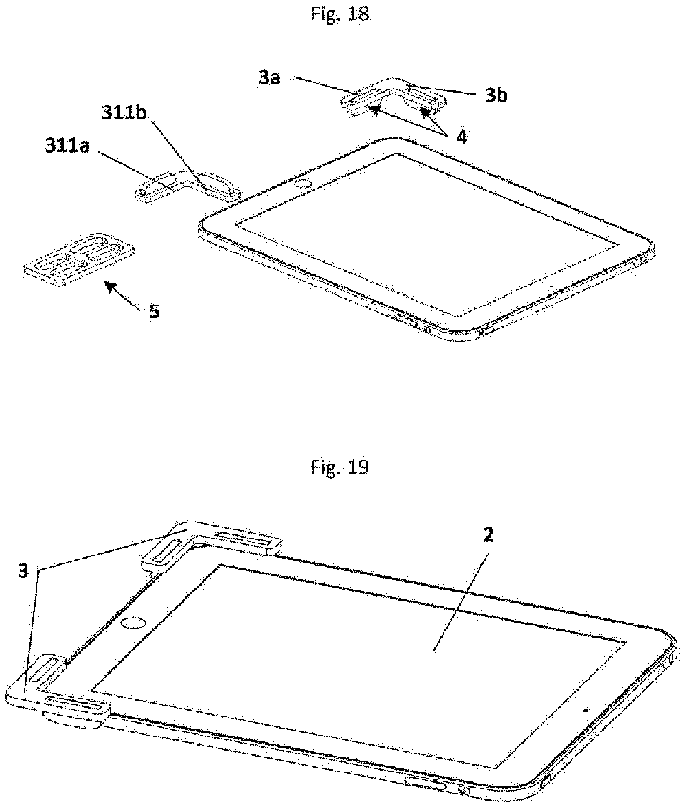

Fig. 18 zeigt eine fünfte Ausführungsform einer erfindungsgemäßen Montagevorrichtung. In der fünften Ausführungsform werden zwei baugleiche L-förmige Anlageelemente 3 verwendet, die jeweils zwei Schenkel 3a, 3b aufweisen, die senkrecht zueinander vorgesehen sind. Die Schenkel 3a und 3b haben die gleiche Länge und weisen je einen Rahmenkoppelabschnitt 34 auf. Somit werden an einem Anlageelement 3 insgesamt zwei Positionierelemente 4 gekoppelt.

In einem Ausgangszustand können die Anlageelemente 4 in einem Abstreichelement 5 mittels Stegen 33 vorgesehen sein. Das Anlageelement 5 kann in einem Ausgangszustand mittels Stegen an den Ausrichtabschnitten 311a, 311b der beiden Anlageelemente 3 vorgesehen sein. Somit bilden die beiden Anlageelemente 3, das Abstreichelement 5 und die vier Positionierelemente 4 eine gemeinsame Plattenform.

Fig. 19 zeigt aus dem Abstreichelement 5 herausgelöste Positionierelemente 4, die an die beiden Anlageelemente 3 gekoppelt sind. Die Montagevorrichtungen sind auf das Gerät aus der Displaynormalenrichtung an benachbarten Ecken des Geräts aufgelegt. Dabei berühren sich die Positionierabschnitte 40 Seitenflächen des Geräts. Somit sind die beiden Anlageelemente 3 an dem Gerät mit Display 2 positioniert.

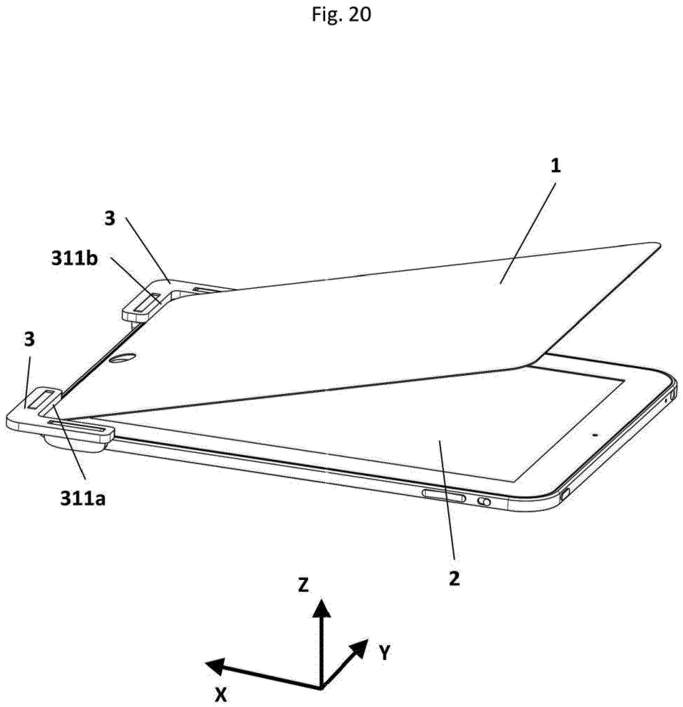

Fig. 20 zeigt einen Displayschutz 1, der an dem ersten Ausrichtabschnitt 311a des einen Anlageelements 3, dem zweiten Ausrichtabschnitt 311b des anderen Anlageelements 3 und auf dem Display 2 anliegt. Mittels Schwenken des Displayschutzes 1 um die Querrichtung Y kann der Displayschutz 1 an das Display 2 gefügt werden.

## Patentansprüche

1. Montagevorrichtung für ein Fügen eines Displayschutzes (1) an ein Display (2) eines Geräts, wobei die Montagevorrichtung beinhaltet:
ein Anlageelement (3), an dem der Displayschutz (1) oder das Gerät positionierbar ist und das einen ersten Schenkel (3a) mit einem ersten Ausrichtabschnitt (311a) aufweist, an dem der Displayschutz (1) in einer ersten Richtung ausrichtbar ist, und einen zweiten Schenkel (3b) mit einem zweiten Ausrichtabschnitt (311b) aufweist, an dem der Displayschutz (1) oder das Gerät in einer zweiten Richtung ausrichtbar ist,
einen Schenkelverbindungsabschnitt (39), der die beiden Schenkel (3a, 3b) in einem festen Winkel verbindet, und
zumindest ein erstes und zumindest ein zweites Positionierbauteil (4) mit einem Koppelabschnitt (44), der mit den Schenkeln (3a, 3b) koppelbar ist, und einem Positionierabschnitt (40), der bezüglich des ersten Ausrichtabschnitts (311a) und bezüglich des zweiten Ausrichtabschnittes (311b) ausgerichtet ist, wenn das erste Positionierbauteil (4) mit dem ersten Schenkel (3a) und das zweite Positionierbauteil (4) mit dem zweiten Schenkel (3b) gekoppelt ist, wobei das Gerät oder der Displayschutz (1) mit zumindest einem Positionierabschnitt (40) zum Ausrichten in Kontakt bringbar ist, um Gerät und Displayschutz (1) zueinander auszurichten,
**dadurch gekennzeichnet, dass**
die Montagevorrichtung aus einem L-förmigen Anlageelement (3) besteht, wobei der erste und der zweite Schenkel (3a, 3b) so angeordnet sind, dass sich für das Anlageelement (3) eine L-Form ergibt.

2. Montagevorrichtung für ein Fügen eines Displayschutzes (1) an ein Display (2) eines Geräts, wobei die Montagevorrichtung beinhaltet:
ein Anlageelement (3), an dem das Gerät oder der Displayschutz (1) positionierbar ist und das einen ersten Schenkel (3a) mit einem ersten Ausrichtabschnitt (311a) aufweist, an dem das Gerät in einer ersten Richtung ausrichtbar ist, und einen zweiten Schenkel (3b) mit einem zweiten Ausrichtabschnitt (311b) aufweist, an dem das Gerät oder der Displayschutz (1) in einer zweiten Richtung ausrichtbar ist,
einen Schenkelverbindungsabschnitt (39), der die beiden Schenkel (3a, 3b) in einem festen Winkel verbindet, und
zumindest ein erstes und zumindest ein zweites Positionierbauteil (4) mit einem Koppelabschnitt (44), der mit den Schenkeln (3a, 3b) koppelbar ist, und einem Positionierabschnitt (40), der bezüglich des ersten Ausrichtabschnitts (311a) und bezüglich des zweiten Ausrichtabschnittes (311b) ausgerichtet ist, wenn das erste Positionierbauteil (4) mit dem ersten Schenkel (3a) und das zweite Positionierbauteil (4) mit dem zweiten Schenkel (3b) gekoppelt ist, wobei der Displayschutz (1) oder das Gerät mit zumindest einem Positionierabschnitt (40) zum Ausrichten in Kontakt bringbar ist, um Gerät und Displayschutz (1) zueinander auszurichten,
**dadurch gekennzeichnet, dass**
die Montagevorrichtung aus einem U- oder J-förmigen Anlageelement (3) besteht, wobei das Anlageelement (3) einen dritten Schenkel (3c) mit einem dritten Ausrichtabschnitt (311c) aufweist, den ein Schenkelverbindungsabschnitt (39) in einem festen Winkel mit dem ersten und/oder zweiten Schenkel (3a, 3b) verbindet, wobei die Schenkel (3a, 3b, 3c) so angeordnet sind, dass sich für das Anlageelement eine U- oder J-förmige Form ergibt.

3. Montagevorrichtung nach Anspruch 1 oder 2, wobei die Positionierbauteile (4) die Ausrichtabschnitte (311a, 311b) des Anlageelements (3) betrachtet entgegen einer Displaynormalenrichtung (Z) überragen, wenn die Positionierbauteile (4) mit den Schenkeln (3a, 3b) gekoppelt sind und das Gerät mit der Montagevorrichtung positioniert ist.

4. Montagevorrichtung nach Anspruch 1 bis 3, wobei das Anlageelement (3) oder das Positionierbauteil (4) einen Auflageabschnitt (37) aufweist, an dem das Display (2) und/oder das Gerät die Montagevorrichtung berührt.

5. Montagevorrichtung nach Anspruch 1 bis 4, wobei die Ausrichtabschnitte (311a, 311b) ebene Flächen sind und/oder mittels Ausrichtverbindungsabschnitten (39) verbindbar sind.

6. Montagevorrichtung nach Anspruch 5, wobei die Ausrichtabschnitte (311a, 311b) in einem Winkel zu einer Fügefläche XY angeordnet sind, wobei die Fügefläche (XY) der Verbindungsfläche von dem Display (2) und dem Displayschutz (1) entspricht.

7. Montagevorrichtung nach Anspruch 1 bis 6, wobei die Montagevorrichtung zumindest ein weiteres Positionierbauteil (4) mit Positionierabschnitt (40) aufweist, das an dem ersten Schenkel (3a), dem zweiten Schenkel (3b) oder dem dritten Schenkel (3c) angeordnet ist und/oder die Positionierbauteile (4) mittels Positionierbauteilkoppelabschnitten (41) miteinander koppelbar sind.

8. Montagevorrichtung nach Anspruch 1 bis 7, wobei ein Positionierabschnitt (40) mit einem Haftelement (46a) versehen ist, das so mit dem Gerät oder dem Displayschutz (1) in Kontakt kommt, dass das Positionierbauteil (4) an dem Gerät oder dem Displayschutz (1) haftet und/oder mit einem Haftelement (46a) versehen ist, das so mit dem Gerät oder dem Displayschutz (1) in Kontakt kommt, dass das Anlageelement (3) an dem Gerät oder dem Displayschutz (1) haftet.

9. Montagevorrichtung nach Anspruch 1 bis 8, wobei das Anlageelement (3) einen Griffabschnitt (38) aufweist.

10. Montagevorrichtung nach Anspruch 1 bis 9, wobei der Schenkelverbindungsabschnitt (39) integral mit Schenkeln (3a, 3b, 3c) oder als ein separates verbindbares Teil ausgeführt ist.

11. Montagevorrichtung nach Anspruch 1 bis 10, wobei die Montagevorrichtung zusätzlich eine Haftauflage aufweist, mittels der die Montagevorrichtung und/oder das Gerät an dem Untergrund anhaften kann.

12. Montagevorrichtung nach Anspruch 1 bis 11, wobei das Anlageelement (3) eine Plattenform hat und die eine Seite eine Plattenoberseite und die andere Seite eine Plattenunterseite bildet.

13. Montagevorrichtung nach Anspruch 12, wobei ein Rahmenkoppelabschnitt (34) aus einer länglichen in Plattendickenrichtung durchgängigen Aussparung besteht und mit dem Koppelabschnitt (44) des Positionierbauteils (4) koppelbar ist.

14. Montagevorrichtung nach Anspruch 13, wobei ein Bereich auf der Plattenunterseite des Anlageelements (3) als Anschlag dient, der die Bewegung eines Positionierbauteils (4) in der Plattendickenrichtung einschränkt.

15. Montagevorrichtung nach Anspruch 12 bis 14, wobei eine Mittelplatte (35) mittels zumindest einem Steg (33) mit dem Anlageelement (3) verbunden ist, wobei ein Positionierbauteil (4) mittels zumindest einem Steg (33) mit der Mittelplatte (35) verbunden ist, und ein Abstreichelement (50) mittels zumindest einem Steg (33) innerhalb der Mittelplatte (35) mit der Mittelplatte (35) verbunden sein kann.

## Claims

1. A mounting device for joining a display protector (1) to a display (2) of an apparatus, the mounting device including:
a contact element (3) on which the display protector (1) or the apparatus is positionable and which has a first leg (3a) with a first alignment portion (311a) on which the display protector (1) can be aligned in a first direction, and a second leg (3b) with a second alignment portion (311b) on which the display protector (1) or the apparatus can be aligned in a second direction,
a leg connecting portion (39) that connects the two legs (3a, 3b) at a fixed angle, and
at least a first and at least a second positioning member (4) having a coupling portion (44) which can be coupled to the legs (3a, 3b), and a positioning portion (40) which is aligned with respect to the first alignment portion (311a) and with respect to the second alignment portion (311b) when the first positioning member (4) is coupled to the first leg (3a) and the second positioning member (4) is coupled to the second leg (3b), wherein the apparatus or the display protector (1) can be brought into contact with at least one positioning portion (40) for alignment in order to align the apparatus and the display protector (1) with respect to each other,
**characterized in that**
the mounting device consists of an L-shaped contact element (3), wherein the first and the second leg (3a, 3b) are arranged such that an L-shape is obtained for the contact element (3).

2. A mounting device for joining a display protector (1) to a display (2) of an apparatus, the mounting device including:
a contact element (3) on which the apparatus or the display protector (1) is positionable and which has a first leg (3a) with a first alignment portion (311a) on which the apparatus can be aligned in a first direction, and a second leg (3b) with a second alignment portion (311b) on which the apparatus or the display protector (1) can be aligned in a second direction,
a leg connecting portion (39) that connects the two legs (3a, 3b) at a fixed angle, and
at least a first and at least a second positioning member (4) having a coupling portion (44) which can be coupled to the legs (3a, 3b), and a positioning portion (40) which is aligned with respect to the first alignment portion (311a) and with respect to the second alignment portion (311b) when the first positioning member (4) is coupled to the first leg (3a) and the second positioning member (4) is coupled to the second leg (3b), wherein the display protector (1) or the apparatus can be brought into contact with at least one positioning portion (40) for alignment in order to align the apparatus and the display protector (1) with respect to each other,
**characterized in that**
the mounting device consists of a U-shaped or J-shaped contact element (3), wherein the contact element (3) has a third leg (3c) with a third alignment portion (311c), which a leg connecting portion (39) connects at a fixed angle to the first and/or second leg (3a, 3b), wherein the legs (3a, 3b, 3c) are arranged such that a U-shaped or J-shaped shape results for the contact element.

3. The mounting device according to claim 1 or 2, wherein the positioning members (4) project beyond the alignment portions (311a, 311b) of the contact element (3), when viewed against a display normal direction (Z), when the positioning members (4) are coupled to the legs (3a, 3b) and the apparatus is positioned with the mounting device.

4. The mounting device according to claim 1 to 3, wherein the contact element (3) or the positioning member (4) has a support portion (37) where the display (2) and/or the apparatus contacts the mounting device.

5. The mounting device according to claim 1 to 4, wherein the alignment portions (311a, 311b) are flat surfaces and/or are connectable by means of alignment connecting portions (39).

6. The mounting device according to claim 5, wherein the alignment portions (311a, 311b) are arranged at an angle to a joining surface (XY), wherein the joining surface (XY) corresponds to the connecting surface of the display (2) and the display protector (1).

7. The mounting device according to claim 1 to 6, wherein the mounting device includes at least one further positioning member (4) with a positioning portion (40), which is arranged on the first leg (3a), the second leg (3b) or the third leg (3c) and/or the positioning members (4) can be coupled to one another by means of positioning member coupling portions (41).

8. The mounting device according to claim 1 to 7, wherein a positioning portion (40) is provided with an adhesive member (46a) which comes into contact with the apparatus or the display protector (1) such that the positioning member (4) adheres to the apparatus or the display protector (1) and/or is provided with an adhesive member (46a) which comes into contact with the apparatus or the display protector (1) such that the contact member (3) adheres to the apparatus or the display protector (1).

9. The mounting device according to claim 1 to 8, wherein the contact element (3) comprises a grip portion (38).

10. The mounting device according to claim 1 to 9, wherein the leg connecting portion (39) is designed to be integral with legs (3a, 3b, 3c) or as a separate connectable part.

11. The mounting device according to claim 1 to 10, wherein the mounting device additionally comprises an adhesive support by means of which the mounting device and/or the apparatus can adhere to the ground.

12. The mounting device according to claim 1 to 11, wherein the contact element (3) has a plate form and the one side forms a plate upper side and the other side forms a plate bottom side.

13. The mounting device according to claim 12, wherein a frame coupling portion (34) consists of an elongated cut-out which is continuous in the plate thickness direction and can be coupled to the coupling portion (44) of the positioning member (4).

14. The mounting device according to claim 13, wherein an area on the plate bottom side of the contact element (3) serves as a stop which restricts the movement of a positioning member (4) in the plate thickness direction.

15. The mounting device according to claim 12 to 14, wherein a central plate (35) is connected to the contact element (3) by means of at least one web (33), wherein a positioning member (4) is connected to the central plate (35) by means of at least one web (33), and a smoothing-out member (50) can be connected to the central plate (35) by means of at least one web (33) within the central plate (35).

## Revendications

1. Dispositif de montage pour ajouter une protection d'écran (1) sur un écran (2) d'un appareil, le dispositif de montage comprenant :
un élément d'appui (3) auquel la protection d'écran (1) ou l'appareil peut être positionné et qui comporte une première branche (3a) avec une première section d'alignement (311a) à laquelle la protection d'écran (1) peut être alignée dans une première direction, et qui comporte une deuxième branche (3b) avec une deuxième section d'alignement (311b) à laquelle la protection d'écran (1) ou l'appareil peut être aligné dans une deuxième direction,
une section de liaison de branches (39) qui relie les deux branches (3a, 3b) selon un angle fixe, et
au moins un premier et au moins un deuxième élément de positionnement (4) avec une section de couplage (44) pouvant être couplé avec les branches (3a, 3b), et une section de positionnement (40) qui est alignée par rapport à la première section d'alignement (311a) et par rapport à la deuxième section d'alignement (311b) lorsque le premier élément de positionnement (4) est couplé avec la première branche (3a) et le deuxième élément de positionnement (4) est couplé avec la deuxième branche (3b), l'appareil ou la protection d'écran (1) pouvant être mis en contact avec au moins une section de positionnement (40) pour l'alignement, afin d'aligner l'appareil et la protection d'écran (1) l'un par rapport à l'autre,
**caractérisé en ce que**
le dispositif de montage consiste en un élément d'appui en forme de L (3), la première et la deuxième branche (3a, 3b) étant disposées de telle sorte que l'élément d'appui (3) présente une forme de L.

2. Dispositif de montage pour ajouter une protection d'écran (1) sur un écran (2) d'un appareil, le dispositif de montage comprenant :
un élément d'appui (3) auquel l'appareil ou la protection d'écran (1) peut être positionné et qui comporte une première branche (3a) avec une première section d'alignement (311a) à laquelle l'appareil peut être aligné dans une première direction, et qui comporte une deuxième branche (3b) avec une deuxième section d'alignement (311b) à laquelle l'appareil ou la protection d'écran (1) peut être aligné dans une deuxième direction,
une section de liaison de branches (39) qui relie les deux branches (3a, 3b) selon un angle fixe, et
au moins un premier et au moins un deuxième élément de positionnement (4) avec une section de couplage (44) pouvant être couplé avec les branches (3a, 3b), et une section de positionnement (40) qui est alignée par rapport à la première section d'alignement (311a) et qui est alignée par rapport à la deuxième section d'alignement (311b) lorsque le premier élément de positionnement (4) est couplé avec la première branche (3a) et que le deuxième élément de positionnement (4) est couplé avec la deuxième branche (3b), la protection d'écran (1) ou l'appareil pouvant être mis en contact avec au moins une section de positionnement (40) pour l'alignement, afin d'aligner l'appareil et la protection d'écran (1) l'un par rapport à l'autre,
**caractérisé en ce que**
le dispositif de montage consiste en un élément d'appui (3) en forme de U ou de J, l'élément d'appui (3) comportant une troisième branche (3c) avec une troisième section d'alignement (311c) qu'une section de liaison de branches (39) relie selon un angle fixe avec la première et/ou la deuxième branche (3a, 3b), les branches (3a, 3b, 3c) étant disposées de telle sorte que l'élément d'appui présente une forme en U ou en J.

3. Dispositif de montage selon la revendication 1 ou 2, dans lequel les éléments de positionnement (4) dépassent les sections d'alignement (311a, 311b) de l'élément d'appui (3) vu dans une direction opposée à une direction normale à l'écran (Z), lorsque les éléments de positionnement (4) sont couplés avec les branches (3a, 3b) et que l'appareil est positionné avec le dispositif de montage.

4. Dispositif de montage selon les revendications 1 à 3, dans lequel l'élément d'appui (3) ou l'élément de positionnement (4) comporte une section d'appui (37) à laquelle l'écran (2) et/ou l'appareil entre en contact avec le dispositif de montage.

5. Dispositif de montage selon les revendications 1 à 4, dans lequel les sections d'alignement (311a, 311b) sont des surfaces planes et/ou peuvent être reliées au moyen de sections de liaison d'alignement (39).

6. Dispositif de montage selon la revendication 5, dans lequel les sections d'alignement (311a, 311b) sont disposées selon un angle par rapport à une surface de jonction (XY), la surface de jonction (XY) correspondant à la surface de liaison de l'écran (2) et de la protection d'écran (1).

7. Dispositif de montage selon les revendications 1 à 6, dans lequel le dispositif de montage comporte au moins un autre élément de positionnement (4) avec une section de positionnement (40), qui est disposé à la première branche (3a), à la deuxième branche (3b) ou à la troisième branche (3c) et/ou les éléments de positionnement (4) peuvent être couplés les uns avec les autres au moyen de sections de couplage d'éléments de positionnement (41).

8. Dispositif de montage selon les revendications 1 à 7, dans lequel une section de positionnement (40) est pourvue d'un élément adhésif (46a) qui entre en contact avec l'appareil ou la protection d'écran (1) de telle sorte que l'élément de positionnement (4) adhère à l'appareil ou à la protection d'écran (1) et/ou est pourvu d'un élément adhésif (46a) qui entre en contact avec l'appareil ou la protection d'écran (1) de telle sorte que l'élément d'appui (3) adhère à l'appareil ou à la protection d'écran (1).

9. Dispositif de montage selon les revendications 1 à 8, dans lequel l'élément d'appui (3) comporte une section de préhension (38).

10. Dispositif de montage selon les revendications 1 à 9, dans lequel la section de liaison de branches (39) est réalisée d'une seule pièce avec des branches (3a, 3b, 3c) ou en tant que pièce séparée pouvant être reliée.

11. Dispositif de montage selon les revendications 1 à 10, dans lequel le dispositif de montage comporte en outre une surface adhésive au moyen duquel le dispositif de montage et/ou l'appareil peut adhérer au support.

12. Dispositif de montage selon les revendications 1 à 11, dans lequel l'élément d'appui (3) a une forme de plaque, et l'un côté forme une face supérieure de plaque et l'autre côté forme une face inférieure de plaque.

13. Dispositif de montage selon la revendication 12, dans lequel une section de couplage de cadre (34) est constituée d'un évidement allongé traversant dans le sens de l'épaisseur de la plaque et peut être couplée à la partie de couplage (44) de l'élément de positionnement (4).

14. Dispositif de montage selon la revendication 13, dans lequel une partie sur la face inférieure de plaque de l'élément d'appui (3) sert de butée qui limite le déplacement d'un élément de positionnement (4) dans le sens de l'épaisseur de la plaque.

15. Dispositif de montage selon les revendications 12 à 14, dans lequel une plaque centrale (35) est reliée à l'élément d'appui (3) au moyen d'au moins une nervure (33), un élément de positionnement (4) étant relié à la plaque centrale (35) au moyen d'au moins une nervure (33), et un élément de raclage (50) pouvant être relié à la plaque centrale (35) au moyen d'au moins une nervure (33) à l'intérieur de la plaque centrale (35).
